# EUROPÄISCHE PATENTSCHRIFT

(11) **EP 1 402 533 B1**
(45) Veröffentlichungstag und Bekanntmachung des Hinweises auf die Patenterteilung: **13.09.2006**
(21) Anmeldenummer: 02758066.1
(22) Anmeldetag: 01.07.2002
(51) Int. Cl.: G11C 13/02, H01L 51/05

(54) **MOLEKULARELEKTRONIK-ANORDNUNG UND VERFAHREN ZUM HERSTELLEN EINER MOLEKULARELEKTRONIK-ANORDNUNG**
MOLECULAR ELECTRONICS ARRANGEMENT AND METHOD FOR PRODUCING A MOLECULAR ELECTRONICS ARRANGEMENT
ENSEMBLE D'ELECTRONIQUE MOLECULAIRE ET PROCEDE POUR LA PRODUCTION D'UN ENSEMBLE D'ELECTRONIQUE MOLECULAIRE

(30) Priorität: 05.07.2001 DE 10132640
(43) Veröffentlichungstag der Anmeldung: 31.03.2004
(73) Patentinhaber: Infineon Technologies AG, 81669 München (DE)
(72) Erfinder: HARTWICH, Jessica, 85579 Neubiberg (DE); KRETZ, Johannes, 80538 München (DE); LUYKEN, Richard, Johannes, 81825 München (DE); RÖSNER, Wolfgang, 85521 Ottobrunn (DE)
(74) Vertreter: Viering, Jentschura & Partner
(86) Internationale Anmeldenummer: PCT/DE2002/002379
(87) Internationale Veröffentlichungsnummer: WO 2003/005369

(56) Entgegenhaltungen:
- WO-A-01/27972
- DE-A- 10 013 013
- US-A- 5 475 341
- US-A- 6 128 214
- NOBUO KIMIZUKA ET AL: "ORGANIC TWO-DIMENSIONAL TEMPLATES FOR THE FABRICATION OF INORGANIC NANOSTRUCTURES: ORGANIC/INORGANIC SUPERLATTICES" ADVANCED MATERIALS, VCH VERLAGSGESELLSCHAFT, WEINHEIM, DE, Bd. 8, Nr. 1, 1996, Seiten 89-91, XP000551322 ISSN: 0935-9648
- GITTINS D I ET AL: "REDOX-CONNECTED MULTILAYERS OF DISCRETE GOLD PARTICLES: A NOVEL ELECTROACTIVE NANOMATERIAL" ADVANCED MATERIALS, VCH VERLAGSGESELLSCHAFT, WEINHEIM, DE, Bd. 11, Nr. 9, 5. Juli 1999 (1999-07-05), Seiten 737-740, XP000851833 ISSN: 0935-9648
- D.I. GITTINS ET AL.: "A nanometre-scale electronic switch consisting of a metal cluster and redox-addressable groups" NATURE, Bd. 408, 2. November 2000 (2000-11-02), Seiten 67-69, XP002226947 MACMILLAN JOURNALS, LONDON, GB ISSN: 0028-0836
- CHEN J ET AL: "LARGE ON-OFF RATIOS AND NEGATIVE DIFFERENTIAL RESISTANCE IN A MOLECULAR ELECTRONIC DEVICE" SCIENCE, AMERICAN ASSOCIATION FOR THE ADVANCEMENT OF SCIENCE,, US, Bd. 286, Nr. 5444, 19. November 1999 (1999-11-19), Seiten 1550-1552, XP000990782 ISSN: 0036-8075 in der Anmeldung erwähnt
- COLLIER C P ET AL: "Electronically configurable molecular-based logic gates" SCIENCE, AMERICAN ASSOCIATION FOR THE ADVANCEMENT OF SCIENCE,, US, Bd. 285, Nr. 5426, 16. Juli 1999 (1999-07-16), Seiten 391-394, XP002149479 ISSN: 0036-8075 in der Anmeldung erwähnt
- ELLENBOGEN J C ET AL: "ARCHITECTURES FOR MOLECULAR ELECTRONIC COMPUTERS: 1. LOGIC STRUCTURES AND AN ADDER DESIGNED FROM MOLECULAR ELECTRONIC DIODES" PROCEEDINGS OF THE IEEE, IEEE. NEW YORK, US, Bd. 88, Nr. 3, März 2000 (2000-03), Seiten 383-426, XP000966283 ISSN: 0018-9219 in der Anmeldung erwähnt

## Beschreibung

Die Erfindung betrifft eine Molekularelektronik-Anordnung und ein Verfahren zum Herstellen einer Molekularelektronik-Anordnung.

Die herkömmliche Silizium-Mikroelektronik wird bei weiter voranschreitender Verkleinerung an ihre Grenzen stoßen. Insbesondere die Entwicklung zunehmend kleinerer und dichter angeordneter Transistoren von mittlerweile mehreren hundert Millionen Transistoren pro Chip wird in den nächsten zehn Jahren prinzipiellen physikalischen Problemen ausgesetzt sein. Wenn Strukturabmessungen von 80 Nanometer unterschritten werden, werden die Bauelemente durch Quanteneffekte störend beeinflusst und unterhalb von Dimensionen von etwa 30 Nanometer dominiert. Auch führt die zunehmende Integrationsdichte der Bauelemente auf einem Chip zu einem dramatischen Anstieg der Abwärme.

Als eine mögliche Nachfolgetechnik der herkömmlichen Halbleiterelektronik ist die Molekularelektronik bekannt, bei der sowohl Elektronenleitung als auch fundamentale Bauelement-Funktionen von geeigneten Molekülen wahrgenommen werden. Eine Übersicht über das Gebiet der Molekularelektronik gibt beispielsweise [1]. Es sind vorwiegend zwei Molekültypen geeignet, um elektronische Bauelementfunktionen zu realisieren. Dies sind einerseits Moleküle auf der Basis von Kohlenstoff-Nanoröhren und andererseits Moleküle auf der Basis von Polyphenylen.

Aus [1] sind Beispiele für molekularelektronische Moleküle bekannt, die in Folge ihrer atomaren Struktur die Fähigkeit aufweisen, die Funktion eines elektrischen Leiters, eines elektrischen Isolators bzw. einer Diode zu erfüllen. Ferner sind aus demselben Dokument Moleküle bekannt, welche die Funktion von Logikgattern wahrnehmen.

Demzufolge sind viele üblicherweise durch herkömmliche Silizium-Mikroelektronik realisierte Bauelementfunktionen auch durch molekularelektronische Moleküle zu bewerkstelligen, wobei die Molekularelektronik gegenüber der herkömmlichen Elektronik den Vorteil einer erheblich geringeren Dimension aufweist. Während die kleinsten heutzutage realisierbaren Halbleiterstrukturen in der Größenordnung von einigen Nanometern liegen, sind bei molekularelektronischen Molekülen Strukturabmessungen bis in den Angström-Bereich denkbar. Damit sind wesentlich kompaktere Anordnungen von Schaltungen möglich und die auftretende Abwärme ist bei molekularelektronischen Schaltkreisen gering.

Ferner ist aus [2] bekannt, dass Bis-Pyridinium-Moleküle die Eigenschaft aufweisen, in zwei Redoxzuständen aufzutreten, wobei das Molekül in den beiden Redoxzuständen eine stark unterschiedliche elektrische Leitfähigkeit aufweist. Im oxidierten Zustand weisen Bis-Pyridinium-Moleküle eine geringe elektrische Leitfähigkeit auf, im reduzierten Zustand ist die elektrische Leitfähigkeit wesentlich höher. Legt man an das Molekül eine ausreichend hohe elektrische Spannung an, so kann man dadurch den Übergang des Moleküls von einem Zustand in den anderen herbeiführen. Die Redoxübergänge sind reversibel. Aufgrund dieser Eigenschaften wird in [2] beschrieben, Bis-Pyridinium-Moleküle als molekularelektronische Nanoschalter zu verwenden.

Infolge ihrer elektrischen Eigenschaften und ihrer geringen Dimension wird in letzter Zeit vielfach die Verwendung organischer, insbesondere biologischer Moleküle für elektronische Anwendungen diskutiert. Dabei tritt das Problem auf, dass die molekularelektronischen Moleküle an geeignete Kontakte, beispielsweise metallische Leiter, anzubinden sind.

Dies ist für die Ankopplung an eine herkömmliche Siliziummikroelektronik erforderlich.

Molekularelektronische Moleküle sind mit funktionalen Gruppen versehen, welche zur chemischen Anbindung an ein Leitermaterial geeignet sind. Als besonders geeignet hat sich die Anbindung von Thiol-Gruppen (SH), die an den Endabschnitten vieler Biomoleküle auftreten, an Leiteroberflächen aus Goldmaterial erwiesen. Die metallischen Leiter sind in einer geeigneten Anordnung in einem Abstand zueinander, der im Nanometerbereich liegt, bereitzustellen, damit die Zwischenräume zwischen zwei solchen Leiteroberflächen von den molekularelektronischen Molekülen überbrückt werden können. Die linearen Ausdehnungen von molekularelektronischen Molekülen liegen typischerweise in der Größenordnung zwischen einigen Angström bis zu hunderten Nanometern.

Aus dem Stand der Technik sind Techniken bekannt, wie ein molekularelektronisches Molekül an zwei seiner Endabschnitte mit Leiteroberflächen gekoppelt werden kann. So wird oftmals beispielsweise mittels Elektronenstrahllithographie eine Gold-Leiterbahn hergestellt, die an ihrer schmalsten Stelle eine Einschnürung von ungefähr 10 Nanometer Breite aufweist. Eine solche Leiterbahn wird dann in einer Biegevorrichtung an der schmalsten Stelle kontrolliert abgerissen, wobei der Abstand zwischen den beiden Abriß-Enden im Nanometerbereich liegt und durch die Biegemechanik einstellbar ist. Gibt man nun eine Lösung mit molekularelektronischen Molekülen zu, deren Ausdehnung im Wesentlichen dem Abstand zwischen den beiden Abriß-Enden entspricht, so können diese Moleküle zum Beispiel über zwei Thiol-Gruppen an die beiden Abriß-Enden, beispielsweise aus Gold-Material, anbinden und diese elektrisch überbrücken.

Wenngleich diese Vorgehensweise für Laborexperimente geeignet ist, ist sie ungeeignet für die Integration vieler molekularer Brücken. Wirtschaftlich interessante Anwendungen der Molekularelektronik zielen allerdings gerade darauf ab, eine Vielzahl molekularelektronischer Kopplungen zwischen metallischen Elektroden auszubilden. Daher ist das beschriebene Verfahren zu zeitaufwändig und zu teuer, als dass es für die Massenproduktion von Anordnungen mit einer großen Vielzahl von molekularelektronischen Bauelementen in Frage käme. Ferner ist der Grad an Reproduzierbarkeit bei dem beschriebenen Verfahren zum Koppeln von metallischen Leitern durch ein molekularelektronisches Molekül gering. Es ist schwierig, das Abreißen der eingeschnürten Goldleiterbahn durch die Biegevorrichtung unter kontrollierten Bedingungen durchzuführen. Ferner erhält man bei jedem Abreißvorgang leicht verschiedene Abreiß-Enden, sodass ein exaktes Einstellen des Abstandes zwischen den Abreiß-Enden nicht möglich ist. Damit molekularelektronische Moleküle aber an zwei Leiteroberflächen immobilisieren können, ist eine sehr genaue Übereinstimmung der linearen Ausdehnung des Moleküls einerseits und des Abstandes zwischen den Leiterebenen andererseits erforderlich.

Alternativ gibt es Vorschläge, zunächst eine Kontaktelektrode herzustellen, anschließend das organische Material aufzubringen (beispielsweise in Form einer monomolekularen Schicht) und anschließend die zweite Elektrode darauf abzuscheiden. Der Herstellungsprozess der zweiten Elektrode ist in diesem Falle so zu wählen, dass das organische Material nicht geschädigt wird, was eine erhebliche Einschränkung ist. Halbleitertechnologische Verfahrensschritte werden häufig bei hohen Temperaturen ausgeführt. Oftmals sind Biomoleküle instabile Verbindungen, die äußerst empfindlich auf zu hohe Temperaturen reagieren. Beispielsweise ist bekannt, dass viele Proteine bereits bei geringfügig oberhalb der Zimmertemperatur liegenden Temperaturen irreversibel denaturieren und somit zerstört werden können. Darüber hinaus ist für viele halbleitertechnologische Verfahren die Anwesenheit aggressiver Chemikalien (z.B. Ätzchemikalien oder Abscheidegase) erforderlich. Dadurch können empfindliche Moleküle leicht zerstört werden. Beispielsweise können Proteine und DNA-Stränge zersetzt werden, wenn der pH-Wert sich zu weit von physiologischen pH-Werten entfernt. Für wirtschaftlich interessante Anordnungen kann allerdings bei Ausbilden der zweiten Elektrode auf die Empfindlichkeit der Moleküle keine Rücksicht genommen werden, wenn die verfahrensgemäß hergestellten Anordnungen wirtschaftlich konkurrenzfähig sein sollen. Andererseits ist auf die Unversehrtheit der Biomoleküle Rücksicht zu nehmen, da Biomoleküle häufig nur in geringen Konzentrationen vorliegen und oft teuer sind. Zum Einbringen empfindlicher, insbesondere temperaturempfindlicher Biomoleküle ist das beschriebene Verfahren daher nur sehr begrenzt geeignet.

Zusammenfassend lässt sich feststellen, dass die bekannten Techniken zum Ausbilden einer Kopplung zweier Metallelektroden durch ein molekularelektronisches Molekül eine Reihe von Nachteilen aufweisen. So sind gemäß den bekannten Techniken strukturell ausreichend definierte Anordnungen nicht herstellbar, die Verfahren sind aufwändig, teuer und für die wirtschaftliche Massenproduktion nicht geeignet.

In [3] und [5] ist jeweils ein chemisch syrithetisiertes elektronisches Bauelement beschrieben, das aus zwei sich kreuzenden Leitern besteht, zwischen denen eine elektrisch adressierbare Molekülspezies angeordnet ist.

Ferner ist in [4] eine molekularelektronische Vorrichtung beschrieben, die zwei leitfähige Kontakte sowie eine leitfähige Brückenverbindung zwischen den zwei Kontakten aufweist. Die leitfähige Brückenverbindung kann mittels eines Spannungsimpulses in einen beliebigen von zwei vorgegebenen Zuständen gebracht werden, in einen ersten Zustand höherer elektrischer Leitfähigkeit oder in einen zweiten Zustand, in dem die leitfähige Brückenverbindung eine gegenüber dem ersten Zustand geringere elektrische Leitfähigkeit aufweist. Die leitfähige Brückenverbindung weist organische Moleküle auf.

[6] beschreibt ein Verfahren zum Antreiben eines Bauelements, welches ein Paar von Elektroden und zwischen diesen eingebettet, eine organische Isolationsschicht aufweist.

Andere molekularelektronische Bauelemente sind in [7], [8], [9] und [10] beschrieben.

Der Erfindung liegt das Problem zugrunde, eine Molekularelektronik-Anordnung zu schaffen, bei der mit verringertem Aufwand molekularelektronische Moleküle präzise an Elektroden ankoppelbar sind, und bei der die molekularelektronischen Moleküle vor Zerstörung besser geschützt sind.

Das Problem wird durch eine Molekularelektronik-Anordnung und ein Verfahren zum Herstellen einer Molekularelektronik-Anordnung mit den Merkmalen gemäß den unabhängigen Patentansprüchen gelöst.

Die Molekularelektronik-Anordnung der Erfindung weist auf ein Substrat, mindestens eine erste Leiterbahn, die eine Oberfläche aufweist, und die in oder auf dem Substrat angeordnet ist, einen auf der Oberfläche der mindestens einen ersten Leiterbahn angeordneten Abstandshalter, der die Oberfläche der mindestens einen ersten Leiterbahn teilweise bedeckt, mindestens eine auf dem Abstandshalter angeordnete zweite Leiterbahn, die eine Oberfläche aufweist, die der Oberfläche der mindestens einen ersten Leiterbahn flächig gegenüberliegt, wobei der Abstandshalter die Oberfläche der mindestens einen zweiten Leiterbahn teilweise bedeckt, und wobei mittels des Abstandshalters ein vorgegebener Abstand zwischen der mindestens einen ersten Leiterbahn und der mindestens einen zweiten Leiterbahn definiert ist. Die Molekularelektronik-Anordnung weist ferner zwischen einem freiliegenden Bereich der Oberfläche der mindestens einen ersten Leiterbahn und einem freiliegenden Bereich der Oberfläche der mindestens einen zweiten Leiterbahn angeordnete molekularelektronische Moleküle auf, deren Länge gleich dem Abstand zwischen der mindestens einen ersten Leiterbahn und der mindestens einen zweiten Leiterbahn ist.

Erfindungsgemäß ist eine Molekularelektronik-Anordnung bereitgestellt, bei welcher der Abstand der mindestens einen ersten Leiterbahn von der mindestens einen zweiten Leiterbahn mittels des bzw. der Abstandshalter genau justierbar ist. Eine Genauigkeit in der Größenordnung einer Atomlage, d.h. von wenigen Angström, ist erreichbar, indem mittels eines geeigneten halbleitertechnologischen Verfahrens, beispielsweise des Atomic Layer Deposition-Verfahrens (ALD-Verfahren), eine definierte Anzahl von Ätomlagen eines Materials auf die mindestens eine erste Leiterbahn aufgebracht wird, wodurch die Dicke des Abstandshalters definiert ist. Da der Abstand der ersten Leiterbahnen von den zweiten Leiterbahnen im Wesentlichen gleich der Länge der dazwischen einzubringenden Moleküle sein sollte, ist der Abstand zwischen den beiden Leiterbahnen erfindungsgemäß auf ein bestimmtes, einzubauendes Molekül anpassbar. Es ist anzumerken, dass die Länge des jeweiligen molekularelektronischen Moleküls abhängig ist von dessen geometrischer Anordnung in dem Zwischenraum zwischen den beiden Leiterbahnen. Anders ausgedrückt bedeutet dies, dass der Abstand zwischen den beiden Leiterbahnen variieren kann um bis zu einen Faktor 2 bezüglich der Länge des jeweiligen molekularelektronischen Moleküls. Der Abstand zwischen den beiden Leiterbahnen ist dabei immer kleiner als die Länge des jeweiligen molekularelektronischen Moleküls.

Die molekularelektronischen Moleküle können in die Molekularelektronik-Anordnung eingebracht werden, wenn die mindestens eine Leiterbahn, die mindestens eine zweite Leiterbahn und der dazwischen angeordnete Abstandshalter bereits ausgebildet sind. Dadurch ist ein schonender Einbau der häufig empfindlichen molekularelektronischen Moleküle, beispielsweise Biomoleküle wie DNA-Stränge oder Proteine, ermöglicht. Dadurch sind die molekularelektronischen Moleküle vor negativen Einflüssen (wie oben bezugnehmend auf den Stand der Technik beschrieben) geschützt.

Bei der Molekularelektronik-Anordnung kann ferner mindestens eine der ersten Leiterbahnen und/oder mindestens eine der zweiten Leiterbahnen mit einem elektrisch leitfähigen Kopplungselement gekoppelt sein, mittels derer die Leiterbahnen an einen externen Schaltkreis ankoppelbar sind. Vorzugsweise ist jedes der mindestens einen elektrisch leitfähigen Kopplungselemente ein mit einem elektrisch leitfähigen Material gefülltes Kontaktloch, welches Kontaktloch in das Substrat eingebracht ist. Das elektrisch leitfähige Kopplungselement kann beispielsweise aus Polysilizium-Material, Aluminium-Material oder Wolfram-Material hergestellt sein.

Die Molekularelektronik-Anordnung kann ferner einen externen Schaltkreis aufweisen, der mittels der elektrisch leitfähigen Kopplungselemente mit mindestens einer der ersten Leiterbahnen und/oder der zweiten Leiterbahnen gekoppelt ist. Vorzugsweise ist der externe Schaltkreis ein integrierter Schaltkreis, der in das Substrat integriert ist. Der externe Schaltkreis kann in CMOS-Technologie hergestellt sein. Das Substrat kann ein Silizium-Wafer sein.

Indem erfindungsgemäß elektrisch leitfähige Kopplungselemente bereitgestellt sind, mittels derer die ersten bzw. zweiten Leiterbahnen an einen externen elektrischen Schaltkreis ankoppelbar sind, sind indirekt auch die molekularelektronischen Moleküle an den externen Schaltkreis ankoppelbar. Somit ist erfindungsgemäß eine Ankopplung molekularelektronischer Moleküle an die herkömmliche Silizium-Mikroelektronik realisiert. Anschaulich ist durch die Erfindung eine Schnittstelle zwischen der mikroskopischen Dimension der molekularelektronischen Moleküle und der makroskopischen Dimension der herkömmlichen Silizium-Mikroelektronik geschaffen. Werden beispielsweise die molekularelektronischen Moleküle als mikroskopische Sensoren und/oder als mikroskopische elektronische Bauelemente (z.B. elektrische Leiter, elektrische Isolatoren, Dioden, Transistoren, Logikgatter) verwendet, so können die molekularelektronischen Moleküle mittels des externen Schaltkreises und mittels der elektrisch leitfähigen, Kopplungselemente angesteuert oder ausgelesen werden.

Die Ankopplung der molekularelektronischen Moleküle an einen externen Schaltkreis ist vorteilhaft, da dies vielfältige Anwendungsmöglichkeiten der Molekularelektronik-Anordnung eröffnet. Beispielsweise können die molekularelektronischen Moleküle als Sensor (beispielsweise für das Vorliegen einer umgebenden Atmosphäre oder das Vorliegen einer umgebenden Temperatur) verwendet werden.

Ferner kann die Molekularelektronik-Anordnung der Erfindung auch als Molekularspeicher verwendet werden. Dafür können in die Molekularelektronik-Anordnung der Erfindung molekularelektronische Moleküle eingebracht werden, bei denen beispielsweise ein elektrisches Signals eine Änderung eines beispielsweise elektrischen Parameters bewirkt (z.B. des elektrischen Widerstandes). Lässt sich beispielsweise durch Anlegen eines externen Spannungssignals der elektrische Widerstand eines Moleküls wahlweise auf einen hohen Wert oder einen niedrigen Wert einstellen, so kann ein molekularelektronisches Molekül als Datenspeicher von einem Bit dienen. Ist das molekularelektronische Molekül in dem Zustand mit einem hohen elektrischen Widerstand, so kann dies als logischer Wert "1" interpretiert werden, ist das molekularelektronische Molekül dagegen in dem Zustand mit einem niedrigen elektrischen Widerstand, so kann dies als logischer Wert "0" interpretiert werden. Das in einem molekularelektronischen Molekül gespeicherte Bit kann beispielsweise durch Anlegen einer Spannung an das molekularelektronische Molekül ausgelesen werden, wobei der Stromfluss durch das molekularelektronische Molekül klein ist, wenn dessen elektrischer Widerstand groß ist (logischer Wert "1") und wobei der Stromfluss durch das molekularelektronische Molekül groß ist, wenn dessen elektrischer Widerstand klein ist (logischer Wert "0").

Die Molekularelektronik-Anordnung der Erfindung bietet zahlreiche weitere Anwendungsmöglichkeiten. So kann beispielsweise ein an eine erste Leiterbahn und an eine zweite Leiterbahn angekoppeltes Biomolekül (beispielsweise ein DNA-Halbstrang, ein Protein, ein Bio-Polymer, eine niedermolekulare Verbindung) mittels der Molekularelektronik-Anordnung untersucht, d.h. charakterisiert werden. Ferner sind alle biologischen Nachweisverfahren, die auf einer elektrischen Kontaktierung von Biomolekülen beruhen, mit der Molekularelektronik-Anordnung der Erfindung ausführbar. Auch kann ein zwischen einer ersten Leiterbahn und einer zweiten Leiterbahn angeordnetes molekularelektronisches Molekül eine elektrische Bauelementfunktion wahrnehmen, beispielsweise als elektrischer Leiter, als elektrischer Nichtleiter, als Diode, als Transistor oder als Logikgatter eingesetzt werden.

Die vielfältigen Anwendungsmöglichkeiten der Molekularelektronik-Anordnung der Erfindung und die damit zusammenhängende wirtschaftliche Attraktivität der Molekularelektronik-Anordnung sind vorteilhaft.

Ferner kann die Molekularelektronik-Anordnung der Erfindung mindestens eine Schutzschicht auf mindestens einem Teil der freiliegenden Oberflächen der ersten und/oder der zweiten Leiterbahnen aufweisen. Die mindestens eine Schutzschicht ist vorzugsweise aus einem oder einer Kombination der Materialien Siliziumdioxid und/oder Siliziumnitrid hergestellt.

Vorzugsweise ist die gesamte Oberfläche der ersten und/oder der zweiten Leiterbahn, die nicht als aktive Kopplungsoberfläche für molekularelektronische Moleküle ausnutzbar ist, mit der Schutzschicht bedeckt. Mit anderen Worten ist vorzugsweise die gesamte Oberfläche der beispielsweise im Wesentlichen quaderförmig ausgestalteten mindestens einen Leiterbahn mit der Schutzschicht versehen, mit Ausnahme desjenigen Oberflächenbereichs, an den molekularelektronische Moleküle angekoppelt sind, die simultan an eine der mindestens einen zweiten Leiterbahn angekoppelt sind. Analog sind vorzugsweise diejenigen Oberflächenbereiche der beispielsweise im Wesentlichen quaderförmig ausgestalteten mindestens einen zweiten Leiterbahn mit der Schutzschicht bedeckt, die von solchen molekularelektronischen Molekülen frei sind, welche molekularelektronischen Moleküle nicht nur mit einem Endabschnitt an die betrachtete zweite Leiterbahn, sondern darüber hinaus mit einem anderen Endabschnitt an eine der ersten Leiterbahnen gekoppelt sind. Alternativ können jedoch auch nur einzelne Bereiche der Oberfläche der mindestens einen ersten Leiterbahnen bzw. der mindestens einen zweiten Leiterbahn mit der Schutzschicht bedeckt sein.

Durch die zumindest teilweise Bedeckung der freiliegenden Oberflächen der mindestens einen ersten und/oder der mindestens einen zweiten Leiterbahn mit einer vorzugsweise aus Siliziumdioxid und/oder aus Siliziumnitrid hergestellten Schutzschicht ist erfindungsgemäß vermieden, dass Biomoleküle an solchen Oberflächen der ersten (bzw. der zweiten) Leiterbahnen ankoppeln, an denen die molekularelektronischen Moleküle mit ihrem anderen Ende aus geometrischen Gründen nicht an eine der zweiten (bzw. der ersten) Leiterbahnen ankoppeln können. Denn molekularelektronische Moleküle, die nicht mit einem Endabschnitt an eine der ersten Leiterbahnen angekoppelt sind und mit ihrem anderen Endabschnitt an eine der zweiten Leiterbahnen angekoppelt sind, sind nicht bestimmungsgemäß verwendbar. Daher gehen solche Moleküle nutzlos verloren. Indem die freien und ungenützten Oberflächen der Leiterbahnen teilweise mit der Schutzschicht abgedeckt sind, ist ein Anbinden der Biomoleküle an diese ungenützten Flächen vermieden. Dadurch sind Kosten für an nur eine Leiterbahnoberfläche angekoppelte molekularelektronische Moleküle eingespart. Dies ist besonders dann vorteilhaft, wenn teure molekularelektronische Moleküle in die Molekularelektronik-Anordnung eingebracht werden sollen. Häufig sind biologische Moleküle nur in geringen Konzentrationen und/oder Volumina erhältlich, sodass es in diesen Fällen entscheidend darauf ankommt, die Zahl nutzlos gebundener molekularelektronischer Moleküle zu minimieren. Dies ist durch die erfindungsgemäße Schutzschicht realisiert.

Dabei ist der Effekt ausgenutzt, dass molekularelektronische Moleküle sehr selektiv nur an ganz bestimmte Oberflächen ankoppeln. Beispielsweise ist bekannt, dass Thiol-Gruppen (SH-Reste) besonders gut an Gold-Oberflächen ankoppeln. Ferner koppeln Thiol-Gruppen, wie sie an den Endabschnitten vieler molekularelektronischer Moleküle auftreten, auch an Platin- bzw. Silber-Oberflächen an. Ferner haften Trichlorsilan-Reste (SiCl₃-Gruppen) gut auf Silizium, Aluminium und Titan. Auch haften Trichlorsilan-Reste gut auf verschiedenen Oxiden, sodass eine Ankopplung von molekularelektronischen Molekülen mit Trichlorsilan-Endgruppen auch an Leitern möglich ist, deren Oberfläche eine dünne Oxidschicht aufweist. Diese Betrachtung zeigt, dass das Material der Schutzschicht so zu wählen ist, dass die molekularelektronischen Moleküle an diesem Material nicht oder nur schlecht anbinden. Siliziumdioxid bzw. Siliziumnitrid sind als Materialien für die Schutzschicht geeignet.

Die mindestens eine erste Leiterbahn bzw. die mindestens eine zweite Leiterbahn ist vorzugsweise aus einem oder einer Kombination der Materialien Gold, Platin, Silber, Silizium, Aluminium und Titan hergestellt. Diese Materialien sind dafür geeignet, an bei molekularelektronischen Molekülen häufig vorkommenden Endgruppen (insbesondere Thiol-Gruppen oder Trichlorsilan-Resten) zu binden.

Der Abstandshalter ist vorzugsweise aus einem oder einer Kombination der Materialien Siliziumdioxid und/oder Siliziumnitrid hergestellt. Indem diese Materialien für den Abstandshalter verwendet werden, ist bezugnehmend auf obige Ausführungen erfindungsgemäß vermieden, dass molekularelektronische Moleküle parasitär an der Oberfläche des Abstandshalters ankoppeln. Daher kann der Abstandshalter, wenn dieser aus einem geeigneten Material hergestellt ist, die Funktionalität der Schutzschicht unterstützen bzw. als Schutzschicht dienen.

Wie oben ausgeführt, ist die beiderseitige Kopplung der molekularelektronischen Moleküle mit den Leiterbahnen beispielsweise durch eine Thiol-Gold-Kopplung und/oder eine Kopplung eines Trichlorsilan-Rests mit einer der Materialien Silizium, Aluminium und Titan.

Vorzugsweise sind bei der Molekularelektronik-Anordnung der Erfindung zumindest ein Teil der molekularelektronischen Moleküle redoxaktive Bis-Pyridinium-Moleküle und/oder Alkyl-Trichlorsilan-Moleküle.

Im Weiteren wird das erfindungsgemäße Verfahren zum Herstellen einer Molekularelektronik-Anordnung beschrieben. Bei dem erfindungsgemäßen Verfahren zum Herstellen einer Molekularelektrikanordnung der Erfindung wird in einem ersten Schritt mindestens eine erste Leiterbahn, die eine Oberfläche aufweist, in bzw. auf die Oberfläche eines Substrats eingebracht bzw. aufgebracht. In einem zweiten Schritt wird auf die Oberfläche der mindestens einen ersten Leiterbahn eine Abstandshalter-Schicht aufgebracht, welche die Oberfläche der mindestens einen ersten Leiterbahn mindestens teilweise bedeckt. In einem dritten Schritt wird mindestens eine zweite Leiterbahn, die eine Oberfläche aufweist, die der Oberfläche der mindestens einen ersten Leiterbahn flächig gegenüberliegt, auf die Abstandshalter-Schicht aufgebracht, wobei mittels der Abstandshalter-Schicht ein Abstand: zwischen der mindestens einen ersten Leiterbahn und der mindestens einen zweiten Leiterbahn vorgegeben wird. In einem vierten Schritt wird der Abstandshalter ausgebildet, indem die Abstandshalter-Schicht teilweise zurückgeätzt wird, derart, dass ein freiliegender Bereich der Oberfläche der mindestens einen ersten Leiterbahn und ein freiliegender Bereich der Oberfläche der mindestens einen zweiten Leiterbahn zurückbleibt. In einem fünften Schritt werden zwischen dem freiliegenden Bereich der Oberfläche der mindestens einen ersten Leiterbahn und dem freiliegenden Bereich der Oberfläche der mindestens einen zweiten Leiterbahn molekularelektronische Moleküle angeordnet, deren Länge gleich dem Abstand zwischen der mindestens einen ersten Leiterbahn und der mindestens einen zweiten Leiterbahn ist.

Wie oben beschrieben, wird in dem ersten Schritt mindestens eine erste Leiterbahn, die eine Oberfläche aufweist, in bzw. auf die Oberfläche eines Substrats eingebracht bzw. aufgebracht.

Vorzugsweise wird die mindestens eine erste Leiterbahn in die Oberfläche des Substrats in Damascene-Technik eingebracht. Die Damascene-Technik ist ein Verfahren, gemäß dem es ermöglicht ist, einen mit einem Metall-Material gefüllten Graben in einem Substrat zu erzeugen. Hierbei wird zunächst das Substrat, in welches das Metall-Material eingebracht werden soll, beispielsweise unter Verwenden der CMP-Technik ("Chemical Mechanical Polishing") planarisiert. Dann wird in das Substrat, in welches das Metallmaterial eingebracht werden soll, mindestens ein Graben geätzt. Anschließend wird in den mindestens einen Graben Metall-Material abgeschieden. Danach wird wiederum unter Verwendung des CMP-Verfahrens ("Chemical Mechanical Polishing") das über die Gräben hinausstehende Leitermaterial durch Polieren entfernt, sodass nur die metallisierte Grabenfüllung zurück bleibt. Auf diese Weise liegt nur die Oberseite der metallischen Leiterbahn frei. Es ist hinzuzufügen, dass das metallische Material beispielsweise durch Verwenden des Sputter-Verfahrens oder durch CVD-Abscheidung ("Chemical Vapour Deposition") in den Graben einbringbar ist.

Wie oben beschrieben, wird die mindestens eine erste Leiterbahn vorzugsweise in die Oberfläche eines Substrats eingebracht, d.h. integriert. Dies ist vorteilhaft, da dadurch die Ankopplung an einen beispielsweise in das Substrat integrierten herkömmlichen mikroelektronischen Siliziumschaltkreis ermöglicht ist.

In dem zweiten erfindungsgemäßen Verfahrensschritt wird auf die Oberfläche der mindestens einen ersten Leiterbahn eine Abstandshalter-Schicht aufgebracht, welche die Oberfläche der mindestens einen ersten Leiterbahn mindestens teilweise bedeckt.

Vorzugsweise wird die Abstandshalter-Schicht auf die Oberfläche der Schichtanordnung mittels des Atomic Layer Deposition-Verfahrens (ALD-Verfahren) aufgebracht. Anschaulich wird mittels der Dicke der Abstandshalter-Schicht der Abstand der mindestens einen ersten Leiterbahn von der mindestens einen zweiten Leiterbahn definiert, wobei die Dicke der Abstandshalter-Schicht im Wesentlichen dem Abstand der beiden molekularen Andockstellen entspricht. Um diesen Abstand mit einer Genauigkeit in der Größenordnung atomarer Abstände (d.h. Abstände im Bereich von wenigen Angström) präzise einstellen zu können, wird zum Abscheiden der Abstandshalter-Schicht auf die mindestens eine Leiterbahn vorzugsweise die Methode der Atomic Layer Deposition (ALD-Verfahren) verwendet. Das ALD-Verfahren ist eine Technik zum Absetzen dünner Schichten auf eine Oberfläche und ist dem CVD-Verfahren ("Chemical Vapour Deposition") verwandt. Anschaulich ist das ALD-Verfahren ein CVD-Verfahren, bei dem durch abwechselndes Einleiten zweier Reaktionsgase in einen Verfahrensraum jeweils eine Atomschicht auf eine Oberfläche abgesetzt wird. Zunächst wird ein erstes Reaktionsgas in einen Verfahrensraum eingeleitet, sodass auf der Oberfläche des mit einer Schicht zu bedeckenden Substrats zunächst eine Atomlage eines Materials abgesetzt wird, das durch das erste Reaktionsgas bestimmt wird. Anschließend wird in den Verfahrensraum ein zweites Reaktionsgas eingeleitet, sodass sich auf der monoatomaren Schicht, die durch das Material des ersten Reaktionsgases bestimmt ist, eine weitere monoatomare Schicht, die durch das Material des zweiten Reaktionsgases bestimmt ist, abgesetzt wird. Nach und nach werden monoatomare Schichten, die durch die Materialien des ersten Reaktionsgases bzw. des zweiten Reaktionsgases definiert sind, auf der Oberfläche der Schichtanordnung abgesetzt. Auf diese Art und Weise entsteht eine Schicht sehr gleichmäßiger Dicke, wobei die Dicke durch die Zahl der Prozessschritte bis auf eine Genauigkeit einer Atomlage, d.h. bis auf die Genauigkeit weniger Angström, eingestellt werden kann. Das exakte Einstellen der Dicke der Schicht kann durch einfaches Zählen der Zahl der Prozessschritte realisiert sein.

Indem die Abstandshalter-Schicht auf die mindestens eine erste Leiterbahn unter Verwendung des ALD-Verfahren aufgebracht wird, ist der Abstand der mindestens einen ersten Leiterbahn von der mindestens einen zweiten Leiterbahn exakt justierbar und so flexibel auf spezielle einzubringende molekularelektronische Moleküle anpassbar. Dies ist ebenso vorteilhaft wie der hohe Grad an Reproduzierbarkeit, der beispielsweise durch Zählen der Prozessschritte, d.h. des Wechselns von einem ersten Reaktionsgas auf ein zweites Reaktionsgas erreicht wird. Vorzugsweise wird die Abstandshalter-Schicht aus einem oder einer Kombination der Materialien Siliziumdioxid und Siliziumnitrid hergestellt.

In einem dritten Verfahrensschritt wird mindestens eine zweite Leiterbahn, die eine Oberfläche aufweist, die der Oberfläche der mindestens einen ersten Leiterbahn flächig gegenüberliegt, auf die Abstandshalter-Schicht aufgebracht, wobei mittels der Abstandshalter-Schicht der Abstand zwischen der mindestens einen ersten Leiterbahn und der mindestens einen zweiten Leiterbahn vorgegeben wird.

Dieser Schritt kann praktisch realisiert werden, indem eine elektrisch leitfähige Schicht auf der Oberfläche der erhaltenen Schichtanordnung abgesetzt und strukturiert wird. Dies kann beispielsweise mittels eines geeigneten Photolithographie- und Ätzverfahrens erfolgen.

Die mindestens eine erste Leiterbahn und/oder die mindestens eine zweite Leiterbahn kann aus einem oder einer Kombination der Materialien Gold, Platin, Silber, Silizium, Aluminium und Titan hergestellt werden.

In einem vierten Schritt wird der Abstandshalter ausgebildet, indem die Abstandshalter-Schicht teilweise zurückgeätzt wird, derart, dass ein freiliegender Bereich der Oberfläche der mindestens einen ersten Leiterbahn und ein freiliegender Bereich der Oberfläche der mindestens einen zweiten Leiterbahn zurückbleibt.

Dieser Verfahrensschritt kann beispielsweise realisiert sein, indem unter Verwendung eines geeigneten Ätzverfahrens, beispielsweise mittels nasschemischen Ätzens, die Abstandshalter-Schicht teilweise weggeätzt wird, so dass mindestens ein Abstandshalter zurückbleibt. Vorzugsweise wird der Abstandshalter unterätzt, d.h. der unterhalb der mindestens einen zweiten Leiterbahn befindliche Abstandshalter wird seitlich so weit zurückgeätzt, dass die mindestens eine zweite Leiterbahn zumindest teilweise seitlich über den Abstandshalter hervorsteht, und dass die unterhalb des Abstandshalters angeordnete mindestens eine erste Leiterbahn seitlich mindestens teilweise über den Abstandshalter hervorsteht. Dadurch wird ein Bereich der Oberfläche der mindestens einen ersten Leiterbahn und ein Bereich der Oberfläche der mindestens einen zweiten Leiterbahn freigelegt. Anschaulich liegen sich die beiden Flächen der mindestens einen ersten Leiterbahn und mindestens einen zweiten Leiterbahn, an die beidseitig ein molekularelektronisches Molekül ankoppelbar ist, annähernd parallel gegenüber, in einem Abstand voneinander, der im Wesentlichen der Länge eines einzubringenden molekularelektronischen Moleküls entspricht.

In einem fünften Verfahrensschritt werden zwischen dem freiliegenden Bereich der Oberfläche der mindestens einen ersten Leiterbahn und dem freiliegenden Bereich der Oberfläche der mindestens einen zweiten Leiterbahn molekularelektronische Moleküle angeordnet, deren Länge gleich dem Abstand zwischen der mindestens einen ersten Leiterbahn und der mindestens einen zweiten Leiterbahn ist.

Wie oben ausgeführt, gibt es bestimmte Materialpaare von Leiteroberflächen und Endabschnitten molekularelektronischer Moleküle, die besonders gut eine Bindung miteinander eingehen, beispielsweise die Thiol-Gold-Bindung. Ist die Oberfläche der verfahrensgemäß freigelegten mindestens einen ersten Leiterbahn bzw. mindestens einen zweiten Leiterbahn aus einem Material hergestellt (beispielsweise aus Gold), das für das Anbinden bestimmter molekularelektronischer Moleküle (beispielsweise solcher, die Thiol-Endgruppen aufweisen) ausreichend gut geeignet ist, so werden die molekularelektronischen Moleküle spontan mit einem Endabschnitt an eine der ersten Leiterbahnen und mit dem anderen Endabschnitt an einen der zweiten Leiterbahnen ankoppeln. Hierzu werden beispielsweise die molekularelektronischen Moleküle in gelöster Form in die Molekularelektronik-Anordnung eingebracht, und es bildet sich automatisch eine Bindung aus (sog. Self-Assembly-Technik).

Die molekularelektronischen Moleküle sind vorzugsweise redoxaktive Bis-Pyridinium-Moleküle und/oder Alkyl-Trichlorsilan-Moleküle.

Wie die obige Beschreibung zeigt, ist die Molekularelektronik-Anordnung der Erfindung durch ein Verfahren herstellbar, dessen Verfahrensschritte standardmäßige halbleitertechnologische Verfahrensschritte sind. Indem verfahrensgemäß ausschließlich Standardtechniken verwendbar sind, die auf standardisierten Maschinen, wie sie in vielen halbleitertechnologischen Labors und Fabriken zur Verfügung stehen, durchführbar sind, ist eine aufwändige Entwicklung von Maschinen zur Verwirklichung des Verfahrens zum Herstellen einer Molekularelektronik-Anordnung entbehrlich. Dies spart Zeit und Entwicklungskosten.

Ferner ist es verfahrensgemäß möglich, eine große Vielzahl von Kopplungen zwischen einer ersten Leiterbahn und einer zweiten Leiterbahn durch molekularelektronische Moleküle herbeizuführen, sodass sich die Molekularelektronik-Anordnung der Erfindung im Unterschied zu den aus dem Stand der Technik bekannten Molekularelektronik-Anordnungen auch für die großtechnische Integration eignet. Damit ist die Molekularelektronik-Anordnung der Erfindung nicht nur für Laborexperimente in der Grundlagenforschung interessant, sondern erschließt der Molekularelektronik auch wirtschaftlich interessante Anwendungsgebiete.

Das Verfahren zum Herstellen einer Molekularelektronik-Anordnung kann den weiteren Verfahrensschritt aufweisen, dass mindestens eine der ersten Leiterbahnen und/oder mindestens eine der zweiten Leiterbahnen mit mindestens einem elektrisch leitfähigen Kopplungselement gekoppelt werden, sodass die Leiterbahnen an einen externen Schaltkreis ankoppelbar sind. Dies kann insbesondere dadurch realisiert werden, dass elektrisch leitfähige Kopplungselemente ausgebildet werden, indem in das Substrat Kontaktlöcher eingebracht werden und die Kontaktlöcher mit einem elektrisch leitfähigen Material gefüllt werden. Vorzugsweise werden die elektrisch leitfähigen Kopplungselemente aus Polysilizium-Material, Aluminium-Material oder Wolfram-Material hergestellt.

Ferner kann mindestens ein Teil der ersten und/oder der zweiten Leiterbahnen mittels der elektrisch leitfähigen Kopplungselemente mit einem elektrischen Schaltkreis gekoppelt werden. Der externe Schaltkreis wird vorzugsweise in das Substrat integriert. Beispielsweise kann der externe Schaltkreis in das Substrat mittels der CMOS-Technologie integriert werden. Als Substrat kann beispielsweise ein Silizium-Wafer verwendet werden.

Dadurch ist eine Ankopplung der molekularelektronischen Moleküle an eine externe herkömmliche Silizium-Mikroelektronik realisiert, was der verfahrensgemäß hergestellten Molekularelektronik-Anordnung viele Anwendungsgebiete erschließt.

Das Verfahrens zum Herstellen einer Molekularelektronik-Anordnung kann ferner vor dem Einbringen der molekularelektronischen Moleküle in die Anordnung den weiteren Verfahrensschritt aufweisen, dass mindestens eine Schutzschicht auf mindestens einen Teil der freiliegenden Bereiche der Oberflächen der ersten und/oder der zweiten Leiterbahnen aufgebracht wird. Die Schutzschicht ist vorzugsweise aus einem oder einer Kombination der Materialien Siliziumdioxid und/oder Siliziumnitrid hergestellt.

Wie oben ausführlich dargestellt, wird durch das Ausbilden einer Schutzschicht auf einem Teil der freiliegenden Oberflächen der ersten Leiterbahnen, an welchen keine molekularelektronischen Moleküle gebunden sind, die darüber hinaus auch an einer der zweiten Leiterbahnen gebunden sind, die Anzahl derjenigen molekularelektronischen Moleküle, die nicht bestimmungsgemäß verwendet werden können, verringert. Analog wird durch Ausbilden der Schutzschicht an dafür geeigneten Oberflächenbereichen der mindestens einen zweiten Leiterbahn die Anzahl derjenigen molekularelektronischen Moleküle verringert, die an die freiliegenden Oberflächen der mindestens einen zweiten Leiterbahnen ankoppeln, ohne gleichzeitig mit einem anderen Endabschnitt an eine der mindestens einen ersten Leiterbahn gekoppelt zu sein. Anschaulich wird durch Ausbilden der Schutzschicht bewirkt, dass ein höherer Anteil der in die Molekularelektronik-Anordnung eingebrachten molekularelektronischen Moleküle bestimmungsgemäß beidseitig an eine der ersten bzw. eine der zweiten Leiterbahnen ankoppeln. Dadurch werden weniger molekularelektronische Moleküle benötigt, was die Kosten reduziert und was das definierte Einbringen solcher molekularelektronischer Moleküle ermöglicht, die nur in sehr geringer Konzentration zur Verfügung stehen.

Alternativ kann gemäß dem erfindungsgemäßen Verfahren zum Herstellen einer Molekularelektronik-Anordnung statt dem Aufbringen der mindestens einen zweiten Leiterbahn auf der Abstandshalter-Schicht eine durchgehende Leiterschicht sowie eine weitere Schutzschicht auf die Anordnung der Oberfläche aufgebracht werden und die durchgehende Leiterschicht und die weitere Schutzschicht derart strukturiert werden, dass dadurch eine mindestens teilweise mit einer weiteren Schutzschicht bedeckte mindestens eine zweite Leiterbahn ausgebildet wird. Die weitere Schutzschicht wird vorzugsweise aus einem oder einer Kombination der Materialien Siliziumdioxid und Siliziumnitrid hergestellt.

Eine weitere Ausgestaltung des erfindungsgemäßen Verfahrens zum Herstellen der Molekularelektronik-Anordnung der Erfindung besteht darin, dass beim Einbringen der molekularelektronischen Moleküle in die Anordnung zumindest an einen Teil der Leiterbahnen jeweils elektrische Spannungen angelegt werden, derart, dass die molekularelektronischen Moleküle mit einer bevorzugten geometrischen Orientierung an eine der mindestens einen ersten Leiterbahnen und an eine der mindestens einen zweiten Leiterbahnen gekoppelt werden.

Die elektrischen Signale, die hierfür erforderlich sind, werden vorzugsweise von dem externen Schaltkreis, der über elektrisch leitfähige Kopplungselemente mit den Leiterbahnen gekoppelt ist, bereitgestellt. Anschaulich wird durch zwischen den ersten Leiterbahnen und den zweiten Leiterbahnen angelegte elektrische Spannungen ein elektrisches Feld ausgebildet. Werden nun molekularelektronische Moleküle in die Anordnung eingebracht, so werden diese molekularelektronischen Moleküle von dem elektrischen Feld beeinflusst, sofern die molekularelektronischen Moleküle ein elektrisches Multipolmoment aufweisen, also zum Beispiel elektrisch geladen sind. So weisen beispielsweise viele Proteine bei physiologischen pH-Werten eine elektrische Ladung auf, die von geladenen Aminosäuren vorwiegend an der Oberfläche der Protein-Moleküle stammt. Auch DNA-Moleküle können eine elektrische Ladung aufweisen, häufig weisen DNA-Halbstränge eine negative elektrische Ladung auf. Infolge des elektrischen Feldes, das durch die an die Leiterbahn angelegten elektrischen Spannungen erzeugt wird, wirkt auf die elektrisch geladenen molekularelektronischen Moleküle eine elektrische Kraft ein. Diese bringen die elektrisch geladenen molekularelektronischen Moleküle bevorzugt in eine geometrische Orientierung, in der die potentielle Energie der molekularelektronischen Moleküle in dem elektrischen Feld minimal ist. Dadurch wird den molekularelektronischen Molekülen beim beiderseitigen Ankoppeln an eine der mindestens einen ersten Leiterbahn und eine der mindestens einen zweiten Leiterbahnen eine Vorzugsrichtung vorgegeben, was den Ordnungsgrad der Anordnung erhöht. Dies hat den Vorteil einer besonders hohen Reproduzierbarkeit.

Ausführungsbeispiele der Erfindung sind in den Figuren dargestellt und werden im Weiteren näher erläutert.

Es zeigen:
- Figur 1A: die chemische Struktur eines Bis-Pyridinium-Moleküls,
- Figur 1B: die chemische Struktur eines Alkyl-Trichlorsilan-Moleküls;
- Figur 2A: eine Querschnittsansicht einer Molekularelektronik-Anordnung gemäß einem ersten Ausführungsbeispiel der Erfindung,
- Figur 2B: eine Querschnittsansicht einer Molekularelektronik-Anordnung gemäß einem zweiten Ausführungsbeispiel der Erfindung,
- Figur 2C: eine Querschnittsansicht einer Molekularelektronik-Anordnung gemäß einem dritten Ausführungsbeispiel der Erfindung,
- Figur 3A: eine Draufsicht einer Molekularelektronik-Anordnung gemäß einem Ausführungsbeispiel der erfindungsgemäßen Molekularelektronik-Anordnung zur Verwendung als Molekularspeicher,
- Figur 3B: einen Querschnitt entlang der Schnittlinie I-I' aus Figur 3A einer Molekularelektronik-Anordnung gemäß dem Ausführungsbeispiel der erfindungsgemäßen Molekularelektronik-Anordnung zur Verwendung als Molekularspeicher,
- Figur 4A: eine Querschnittsansicht einer Schichtanordnung nach einem ersten Verfahrensabschnitt gemäß einem bevorzugten Ausführungsbeispiel des erfindungsgemäßen Verfahrens zum Herstellen einer Molekularelektronik-Anordnung,
- Figur 4B: eine Querschnittsansicht einer Schichtanordnung nach einem zweiten Verfahrensabschnitt gemäß dem bevorzugten Ausführungsbeispiel des erfindungsgemäßen Verfahrens zum Herstellen einer Molekularelektronik-Anordnung,
- Figur 4C: eine Querschnittsansicht einer Schichtanordnung nach einem dritten Verfahrensabschnitt gemäß dem bevorzugten Ausführungsbeispiel des erfindungsgemäßen Verfahrens zum Herstellen einer Molekularelektronik-Anordnung,
- Figur 4D: eine Querschnittsansicht einer Schichtanordnung nach einem vierten Verfahrensabschnitt gemäß dem bevorzugten Ausführungsbeispiel des erfindungsgemäßen Verfahrens zum Herstellen einer Molekularelektronik-Anordnung,
- Figur 4E: eine Querschnittsansicht einer Schichtanordnung nach einem fünften Verfahrensabschnitt gemäß dem bevorzugten Ausführungsbeispiel des erfindungsgemäßen Verfahrens zum Herstellen einer Molekularelektronik-Anordnung,
- Figur 5A: eine Querschnittsansicht einer Schichtanordnung nach einem fünften Verfahrensabschnitt gemäß einem anderen bevorzugten Ausführungsbeispiel des erfindungsgemäßen Verfahrens zum Herstellen einer Molekularelektronik-Anordnung,
- Figur 5B: eine Querschnittsansicht einer Schichtanordnung nach einem sechsten Verfahrensabschnitt gemäß dem anderen bevorzugten Ausführungsbeispiel des erfindungsgemäßen Verfahrens zum Herstellen einer Molekularelektronik-Anordnung,
- Figur 5C: eine Querschnittsansicht einer Schichtanordnung nach einem siebten Verfahrensabschnitt gemäß dem anderen bevorzugten Ausführungsbeispiel des erfindungsgemäßen Verfahrens zum Herstellen einer Molekularelektronik-Anordnung,
- Figur 5D: eine Querschnittsansicht einer Schichtanordnung nach einem achten Verfahrensabschnitt gemäß dem anderen bevorzugten Ausführungsbeispiel des erfindungsgemäßen Verfahrens zum Herstellen einer Molekularelektronik-Anordnung,
- Figur 5E: eine Querschnittsansicht einer Schichtanordnung nach einem neunten Verfahrensabschnitt gemäß dem anderen bevorzugten Ausführungsbeispiel des erfindungsgemäßen Verfahrens zum Herstellen einer Molekularelektronik-Anordnung,
- Figur 6A: eine Querschnittsansicht einer Schichtanordnung nach einem dritten Verfahrensabschnitt gemäß einem weiteren bevorzugten Ausführungsbeispiel des erfindungsgemäßen Verfahrens zum Herstellen einer Molekularelektronik-Anordnung,
- Figur 6B: eine Querschnittsansicht einer Schichtanordnung nach einem vierten Verfahrensabschnitt gemäß dem weiteren bevorzugten Ausführungsbeispiel des erfindungsgemäßen Verfahrens zum Herstellen einer Molekularelektronik-Anordnung,
- Figur 6C: eine Querschnittsansicht einer Schichtanordnung nach einem fünfen Verfahrensabschnitt gemäß dem weiteren bevorzugten Ausführungsbeispiel des erfindungsgemäßen Verfahrens zum Herstellen einer Molekularelektronik-Anordnung,
- Figur 6D: eine Querschnittsansicht einer Schichtanordnung nach einem sechsten Verfahrensabschnitt gemäß dem weiteren bevorzugten Ausführungsbeispiel des erfindungsgemäßen Verfahrens zum Herstellen einer Molekularelektronik-Anordnung.

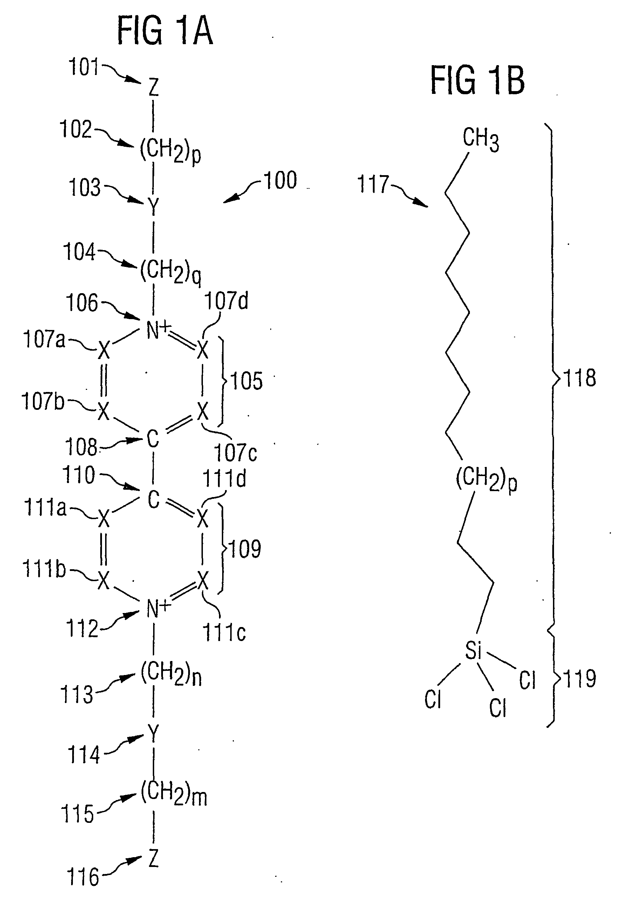

Zunächst werden bezugnehmend auf **Fig. 1A, Fig. 1B** Ausführungsbeispiele für molekularelektronische Moleküle beschrieben, wie sie in der Molekularelektronik-Anordnung der Erfindung enthalten sind.

Bezugnehmend auf **Fig. 1A** wird im Weiteren die Struktur von redoxaktiven Bis-Pyridinium-Molekülen 100 beschrieben. Wie aus [2] bekannt, lässt sich der elektrische Widerstand von redoxaktiven Bis-Pyridinium-Molekülen 100 zwischen zwei Werten hin und her schalten, wobei in dem reduzierten Redoxzustand der elektrische Widerstand gering ist und wobei in dem oxidierten Redoxzustand der elektrische Widerstand hoch ist.

Das in **Fig. 1A** gezeigte redoxaktive Bis-Pyridinium-Molekül 100 weist einige Substituenten (bezeichnet mit X, Y, Z) auf, die als Platzhalter für ein chemisches Element oder eine chemische Gruppe bzw. für einen Molekül-Rest dienen. Ferner sind in dem in **Fig. 1A** gezeigten Bis-Pyridinium-Molekül 100 Variablen p, q, n, m gezeigt, von denen jede voneinander unabhängig einen ganzzahligen positiven Wert (1, 2, 3, ...) einnimmt.

Das in **Fig. 1A** gezeigte Bis-Pyridinium-Molekül 100 weist auf einen mit Z bezeichneten ersten Substituenten 101, der mit einer ersten Alkyl-Gruppe 102 gekoppelt ist. Die erste Alkyl-Gruppe 102 ist ferner mit einem mit Y bezeichneten zweiten Substituenten 103 gekoppelt, und der zweite Substituent 103 ist ferner mit einer zweiten Alkyl-Gruppe 104 gekoppelt. Die zweite Alkyl-Gruppe 104 ist ferner mit einem ersten Stickstoff-Ion 106 gekoppelt, welches erste Stickstoff-Ion 106 Teil des ersten Sechsrings 105 ist. Der erste Sechsring 105 weist eine wabenartige Struktur von sechs zu einem Ring geschlossenen Komponenten auf, unter anderem weist der erste Sechsring 105 vier dritte Substituenten 107a, 107b, 107c, 107d auf. Das positiv geladene Stickstoff-Ion 106 ist mit dem ersten der dritten Substituenten 107a gekoppelt, der erste der dritten Substituenten 107a ist mit dem zweiten der dritten Substituenten 107b gekoppelt, der zweite der dritten Substituenten 107b ist mit einem ersten Kohlenstoffatom 108 gekoppelt, das erste Kohlenstoffatom 108 ist mit dem dritten der dritten Substituenten 107c gekoppelt, der dritte der dritten Substituenten 107c ist mit dem vierten der dritten Substituenten 107d gekoppelt und der vierte der dritten Substituenten 107d ist mit dem Stickstoff-Ion 106 gekoppelt, wodurch die ringförmige Anordnung der Atome bzw. Moleküle 106, 107a, 107b, 108, 107c, 107d geschlossen ist. Der erste der dritten Substituenten 107a, der zweite der dritten Substituenten 107b, der dritte der dritten Substituenten 107c und der vierte der dritten Substituenten 107d sind jeweils mit den Platzhalter X bezeichnet. Wie weiter in **Fig. 1A** gezeigt, ist das erste Kohlenstoffatom 108 des ersten Sechsrings 105 mit einem zweiten Kohlenstoffatom 110 eines zweiten Sechsrings 109 gekoppelt. Der zweite Sechsring 109 weist wie der erste Sechsring 105 eine ringartige Struktur von sechs Atomen bzw. Molekülen auf, unter anderem weist der zweite Sechsring 109 vier vierte Substituenten 111a, 111b, 111c, 111d auf. Das zweite Kohlenstoffatom 110 ist mit dem ersten der vierten Substituenten 111a gekoppelt, der erste der vierten Substituenten 111a ist mit dem zweiten der vierten Substituenten 111b gekoppelt, der zweite der vierten Substituenten 111b ist mit einem zweiten Stickstoff-Ion 112 gekoppelt, das zweite Stickstoff-Ion 112 ist mit dem dritten der vierten Substituenten 111c gekoppelt, der dritte der vierten Substituent 111c ist mit dem vierten der vierten Substituenten 111d gekoppelt und der vierte der vierten Substituenten 111d ist mit dem zweiten Kohlenstoffatom 110 gekoppelt, um die ringförmige Struktur des zweiten Sechsrings 109 zu schließen. Der erste der vierten Substituenten 111a, der zweite der vierten Substituenten 111b, der dritte der vierten Substituenten 111c und der vierte der vierten Substituenten 111d sind jeweils mit den Platzhalter X bezeichnet. Das zweite Stickstoff-Ion 112 ist ferner mit einer dritten Alkyl-Gruppe 113 gekoppelt, die dritte Alkyl-Gruppe 113 ist ferner mit einem fünften Substituenten 114 gekoppelt, der gemäß **Fig. 1A** mit den Platzhalter Y bezeichnet ist. Der fünfte Substituent 114 ist mit einer vierten Alkyl-Gruppe 115 gekoppelt und die vierte Alkyl-Gruppe 115 ist mit einem sechsten Substituenten 116 gekoppelt. Der sechste Substituent 116 ist mit dem Platzhalter Z bezeichnet. Der erste Substituent 101 und der sechste Substituent 116 stellen zwei Endabschnitte des Bis-Pyridinium-Moleküls 100 dar.

Vorzugsweise steht jeder der Platzhalter X für eine CH-Gruppe, eine CR-Gruppe, ein Stickstoffatom, ein Sauerstoffatom oder ein Schwefelatom. Der Buchstabe R in der oben genannten CR-Gruppe stellt selbst wieder einen Platzhalter dar, der vorzugsweise eine Alkyl-Gruppe, eine Aryl-Gruppe, eine Benzyl-Gruppe, eine CN-Gruppe, eine COOH-Gruppe, eine COOR'-Gruppe, eine CONHR'-Gruppe, eine NO₂₋Gruppe, eine OH-Gruppe, eine OR'-Gruppe, eine NH₂-Gruppe, eine NHR'-Gruppe, eine NR'R" -Gruppe, eine SH-Gruppe, eine SR'-Gruppe oder ein anderes chemisch geeignetes Element oder einen anderen chemisch geeigneten Rest darstellt. Mit R' bzw. R" sind wiederum beliebige, chemisch geeignete Reste bzw. Gruppen bezeichnet, beispielsweise Alkyl-Gruppen.

Ferner bezeichnet jeder der Platzhalter Y eine CH₂-Gruppe, ein Sauerstoffatom, eine NH-Gruppe, eine NR'-Gruppe, eine COO-Gruppe, eine CONH-Gruppe, eine CH=CH-Gruppe, eine C≡C-Gruppe, eine Aryl-Gruppe oder ein anderes chemisch geeignetes Element oder einen anderen chemisch geeigneten Rest. Mit R' sind wiederum beliebige, chemisch geeignete Reste bzw. Gruppen bezeichnet, beispielsweise Alkyl-Gruppen.

Darüber hinaus steht jeder der Platzhalter Z für eine CH₃₋Gruppe, eine CH=CH₂-Gruppe, eine SH-Gruppe, eine Schwefel-Schwefel-Gruppe, eine SiCl₃-Gruppe, eine Si(OR')₃-Gruppe, eine SiR₂(OR')-Gruppe, eine PO₃H-Gruppe oder für ein anderes chemisch geeignetes Element oder für einen anderen chemisch geeigneten Rest. Mit R' sind wiederum beliebige, chemisch geeignete Reste bzw. Gruppen bezeichnet, beispielsweise Alkyl-Gruppen.

Es sei nochmals darauf hingewiesen, dass die Variablen m, n, p, q unabhängig voneinander jede positive ganze Zahl sein können.

In **Fig. 1A** ist ein Bis-Pyridinium-Molekül 100 gezeigt, das eine Reihe von Doppelbindungen aufweist (z.B. innerhalb des ersten Sechsrings 105). Für bestimmte Kombinationen von Substituenten können sich anstelle dieser Doppelbindungen Einzelbindungen ergeben, z.B. wenn für den Platzhalter X zweibindiger Sauerstoff gewählt ist.

Gemäss einem bevorzugten Ausführungsbeispiel der Erfindung weist das Bis-Pyridinium-Molekül 100 Endabschnitte Z 101, 116 auf, die Thiol-Gruppen sind (SH-Reste). Es ist bekannt, dass Thiol-Gruppen besonders gut an Gold-Oberflächen immobilisieren.

Als zweites Beispiel für ein molekularelektronisches Molekül ist in **Fig. 1B** ein Alkyl-Trichlorsilan-Molekül 117 gezeigt. Dieses weist eine Alkyl-Gruppe 118 und einen Trichlorsilan-Rest (SiCl₃-Gruppe) 119 auf. Die Alkyl-Gruppe 118 weist eine CH₃-Gruppe in einem Endabschnitt des Alkyl-Trichlorsilan-Moleküls 117 auf und weist ferner p in Serie angeordnete CH₂₋Gruppen auf. Die Variable p kann dabei wiederum jede ganzzahlige positive Zahl sein. Die Alkyl-Gruppe 118 ist mit einem Trichlorsilan-Rest 119 gekoppelt, wobei sich der Trichlorsilan-Rest 119 an dem anderen Endabschnitt des Alkyl-Trichlorsilan-Moleküls 117 befindet. Es ist bekannt, dass sich Trichlorsilan-Reste 119 besonders gut an Silizium, Aluminium und Titan ankoppeln lassen. Ferner lassen sich Trichlorsilan-Reste 119 auch an verschiedene Oxide ankoppeln. Um eine derartige Ankopplung zu realisieren, kann beispielsweise eine dünne Oberflächenschicht eines Oxids auf einem Leiter verwendet werden.

Es ist zu betonen, dass die in **Fig. 1A, Fig. 1B** gezeigten und oben beschriebenen Moleküle 100, 117 nur als Beispiele für mögliche molekularelektronische Moleküle genannt sind, welche die Molekularelektronik-Anordnung der Erfindung aufweisen kann. Die Molekularelektronik-Anordnung der Erfindung kann ferner molekularelektronische Moleküle aufweisen, die beispielsweise Proteine, DNA-Halbstränge, DNA-Moleküle, niedermolekulare Verbindungen, Polypeptide, Polymere oder sonstige geeignete chemische Verbindungen sind. Auch können als molekularelektronische Moleküle Nanoröhren, insbesondere Kohlenstoffnanoröhren, verwendet werden.

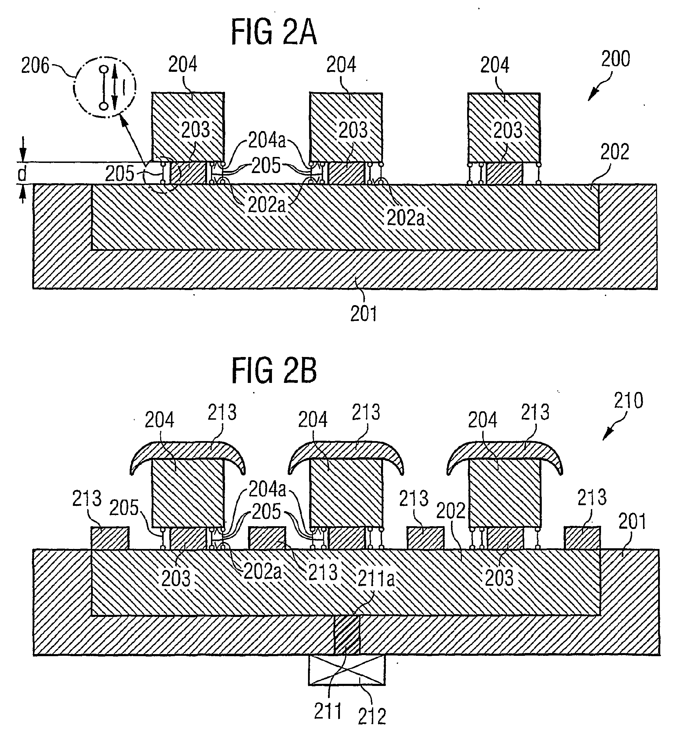

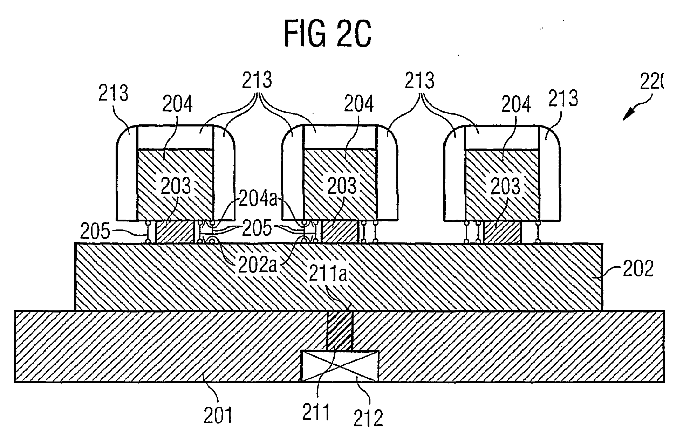

In **Fig. 2A** ist eine Molekularelektronik-Anordnung 200 gemäß einem ersten bevorzugten Ausführungsbeispiel der Erfindung gezeigt.

Die Molekularelektronik-Anordnung 200 weist auf ein Substrat 201, mindestens eine erste Leiterbahn 202, die eine Oberfläche 202a aufweist, und die in dem Substrat 201 angeordnet ist, einen auf der Oberfläche 202a der mindestens einen ersten Leiterbahn 202 angeordneten Abstandshalter 203, der die Oberfläche 202a der mindestens einen ersten Leiterbahn 202 teilweise bedeckt, mindestens eine auf dem Abstandshalter 203 angeordnete zweite Leiterbahn 204, die eine Oberfläche 204a aufweist, die der Oberfläche 202a der mindestens einen ersten Leiterbahn 202 flächig gegenüberliegt, wobei der Abstandshalter 203 die Oberfläche 204a der mindestens einen zweiten Leiterbahn 204 teilweise bedeckt, und wobei mittels des Abstandshalters 203 ein vorgegebener Abstand zwischen der mindestens einen ersten Leiterbahn 202 und der mindestens einen zweiten Leiterbahn 204 definiert ist, und zwischen einem freiliegenden Bereich der Oberfläche 202a der mindestens einen ersten Leiterbahn 202 und einem freiliegenden Bereich der Oberfläche 204a der mindestens einen zweiten Leiterbahn 204 angeordnete molekularelektronische Moleküle 205, deren Länge gleich dem Abstand zwischen der mindestens einen ersten Leiterbahn 202 und der mindestens einen zweiten Leiterbahn 204 ist.

Ferner ist in **Fig. 2A** eine vergrößerte Darstellung eines molekularelektronischen Moleküls 206 gezeigt. Die Länge des molekularelektronischen Moleküls ist in dieser vergrößerten Darstellung eines molekularelektronischen Moleküls 206 mit "l" bezeichnet. Ferner ist in **Fig. 2A** die Dicke "d" des Abstandshalters 203 gezeigt, mittels derer ein vorgegebener Abstand "d" zwischen der mindestens einen ersten Leiterbahn 202 und der mindestens einen zweiten Leiterbahn 204 definiert ist.

Gemäß dem in **Fig. 2A** gezeigten Ausführungsbeispiel ist das Substrat 201 ein vorprozessierter Silizium-Wafer, die mindestens eine erste Leiterbahn 202 und die mindestens eine zweite Leiterbahn 204 sind aus Gold-Material hergestellt, und der Abstandshalter 203 ist aus Siliziumdioxid-Material hergestellt. Gemäß dem in **Fig. 2A** gezeigten Ausführungsbeispiel der Molekularelektronik-Anordnung 200 sind die molekularelektronischen Moleküle 205 Bis-Pyridinium-Moleküle. Die beiderseitige Kopplung der Bis-Pyridinium-Moleküle mit den Leiterbahnen 202, 204 ist als Thiol-Gold-Kopplung realisiert. Wie in **Fig. 2A** weiter gezeigt, sind die molekularelektronischen Moleküle 205 an zwei ihrer Endabschnitte an eine der ersten Leiterbahnen und an eine der zweiten Leiterbahnen gekoppelt, was dadurch ermöglicht ist, dass die Dicke "d" des Abstandshalters 203 im Wesentlichen gleich der Länge "l" der molekularelektronischen Moleküle 205 ist.

In **Fig. 2B** ist eine Molekularelektronik-Anordnung 210 gemäß einem zweiten bevorzugten Ausführungsbeispiel der Erfindung gezeigt.

Die in **Fig. 2B** gezeigte Molekularelektronik-Anordnung 210 weist die Merkmale der Molekularelektronik-Anordnung 200 auf, und die Molekularelektronik-Anordnung 210 weist darüber hinaus weitere Merkmale auf. Jede der ersten Leiterbahnen 202 und jede der zweiten Leiterbahnen 204 ist jeweils mit einem elektrisch leitfähigen Kopplungselement 211 gekoppelt, mittels derer die Leiterbahnen 202, 204 an einen externen Schaltkreis ankoppelbar sind. In **Fig. 2B** ist nur das elektrisch leitfähige Kopplungselement 211 gezeigt, das mit der ersten Leiterbahn 202 gekoppelt ist. Jedoch ist auch jede der drei in **Fig. 2B** gezeigten zweiten Leiterbahnen 204 jeweils mit einem elektrisch leitfähigen Kopplungselement gekoppelt (nicht gezeigt in **Fig. 2B**). Das elektrisch leitfähige Kopplungselement 211 ist gemäß dem in **Fig. 2B** gezeigten Ausführungsbeispiel der Molekularelektronik-Anordnung 210 ein mit einem elektrisch leitfähigen Material gefülltes Kontaktloch 211a, welches Kontaktloch 211a in das Substrat 201 eingebracht ist. Das elektrisch leitfähige Kopplungselement 211 ist gemäß dem beschriebenen Ausführungsbeispiel aus Wolfram-Material hergestellt.

Ferner weist die Molekularelektronik-Anordnung 210 einen externen Schaltkreis 212 auf, der mittels der elektrisch leitfähigen Kopplungselemente 211 mit den ersten Leiterbahnen 202 und den zweiten Leiterbahnen 204 gekoppelt ist. Die Kopplung der ersten Leiterbahn 202 mit dem externen Schaltkreis 212 ist in **Fig. 2B** eingezeichnet und erfolgt über das elektrisch leitfähige Kopplungselement 211. Auch die drei in **Fig. 2B** gezeigten zweiten Leiterbahnen 204 sind mit dem externen Schaltkreis 212 mittels elektrisch leitfähiger Kopplungselemente gekoppelt (nicht gezeigt in **Fig. 2B**). Erfindungsgemäß ist somit der Schaltkreis 212, der ein herkömmlicher mikroelektronischer Schaltkreis ist, über das Kopplungselement 211 und die Leiterbahnen 202, 204 an die molekularelektronischen Moleküle 205 angekoppelt.

Ferner weist die Molekularelektronik-Anordnung 210 eine Schutzschicht 213 auf einem Teil der freiliegenden Oberflächen der ersten Leiterbahnen 202 und der zweiten Leiterbahnen 204 auf. Gemäß dem in **Fig. 2B** gezeigten Ausführungsbeispiel der Molekularelektronik-Anordnung 210 ist die Schutzschicht 213 aus Siliziumdioxid-Material hergestellt.

Die Schutzschicht 213 weist gemäß **Fig. 2B** sieben Teilabschnitte auf, drei kappenartige Bedeckungen der zweiten Leiterbahnen 204 und vier quaderförmige Bedeckungen der ersten Leiterbahn 202.Wie in **Fig. 2B** gezeigt, sind diejenigen Oberflächenbereiche der ersten Leiterbahn 202 bzw. der zweiten Leiterbahn 204, auf denen die Schutzschicht 213 aufgebracht ist, keine geeigneten Bereiche, um darauf molekularelektronische Moleküle 205 anzubinden, derart, dass die molekularelektronischen Moleküle 205 mit einem Endabschnitt an eine erste Leiterbahn 202 und mit dem anderen Endabschnitt an eine zweite Leiterbahn 204 angekoppelt sind. Die mit der Schutzschicht 213 bedeckten Oberflächenbereiche der ersten und zweiten Leiterbahn 202, 204 sind deshalb ungeeignet zum beidseitigen Anbinden von molekularelektronischen Molekülen 205, da von diesen Oberflächen ausgehend nicht in einem Abstand "d", welcher der Länge "l" der molekularelektronischen Moleküle 205 entspricht, eine weitere Leiterbahn angeordnet ist, um die zweite Kopplungsstelle bereitzustellen. Alle molekularelektronischen Moleküle 205, die an derartigen Oberflächen der ersten bzw. zweiten Leiterbahnen 202, 204 andocken, sind bestimmungsgemäß nicht verwendbar. Die elektrische Schutzschicht 213 dient daher dazu, das Anbinden von molekularelektronischen Molekülen 205 an ungeeignete Oberflächenbereiche der ersten bzw. zweiten Leiterbahn 202, 204 zu vermeiden.

In **Fig. 2C** ist eine Molekularelektronik-Anordnung 220 gemäß einem dritten bevorzugten Ausführungsbeispiel der Erfindung gezeigt. Die in **Fig. 2C** gezeigte Molekularelektronik-Anordnung 220 unterscheidet sich von der in **Fig. 2B** gezeigten Molekularelektronik-Anordnung 210 im Wesentlichen hinsichtlich folgender Gesichtspunkte.

Zum einen ist die erste Leiterbahn 202 gemäß dem in **Fig. 2C** gezeigten Ausführungsbeispiel der Molekularelektronik-Anordnung 220 auf dem Substrat 201 angeordnet, und nicht wie gemäß dem in **Fig. 2B** gezeigten Ausführungsbeispiel der Molekularelektronik-Anordnung 210 in dem Substrat 201 integriert.

Ferner ist gemäß der Molekularelektronik-Anordnung 220 der externe Schaltkreis 212 als integrierter Schaltkreis vorgesehen, der in das Substrat 201 eingebracht ist. Der externe Schaltkreis 212 ist in CMOS-Technologie hergestellt.

Die Schutzschicht 213 ist gemäß dem in **Fig. 2C** gezeigten Ausführungsbeispiel der Molekularelektronik-Anordnung 220 aus Siliziumnitrid-Material hergestellt. Die Schutzschicht 213 aus **Fig. 2C** weist drei Teilbereiche auf, wobei jeder dieser drei Teilbereiche der Schutzschicht 213 auf einer der drei zweiten Leiterbahnen 204 aufgebracht ist, um diese im wesentlichen U-förmig zu ummanteln. Die erste Leiterbahn 202 ist **Fig. 2C** zufolge frei von einer Schutzschicht 213.

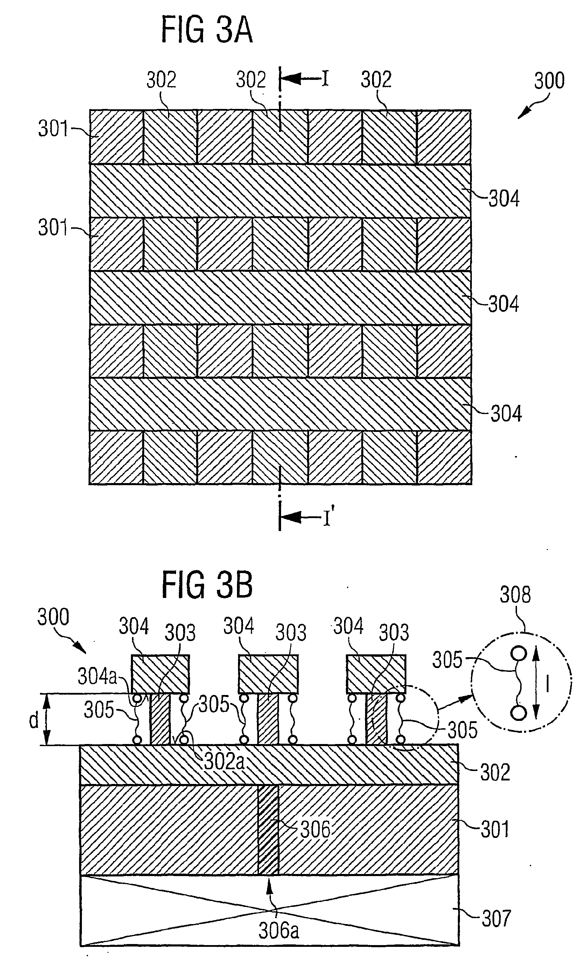

In **Fig. 3A** ist eine Draufsicht und in **Fig. 3B** ist eine Querschnittsansicht entlang der Schnittlinie I-I' einer Molekularelektronik-Anordnung 300 gemäß einem Ausführungsbeispiel der erfindungsgemäßen Molekularelektronik-Anordnung zur Verwendung als Molekularspeicher gezeigt. Die Molekularelektronik-Anordnung 300 weist auf ein Substrat 301, drei erste Leiterbahnen 302, die eine Oberfläche 302a aufweisen, und die in dem Substrat 301 angeordnet sind, einen auf der Oberfläche 302a der drei ersten Leiterbahnen 302 angeordneten Abstandshalter 303, der die Oberfläche 302a der drei ersten Leiterbahnen 302 teilweise bedeckt, drei auf dem Abstandshalter 303 angeordnete zweite Leiterbahnen 304, die eine Oberfläche 304a aufweisen, die der Oberfläche 302a der drei ersten Leiterbahnen 302 flächig gegenüberliegt, wobei der Abstandshalter 303 die Oberfläche der drei zweiten Leiterbahnen 304 teilweise bedeckt, und wobei mittels des Abstandshalters 303 ein vorgegebener Abstand zwischen den drei ersten Leiterbahnen 302 und den drei zweiten Leiterbahnen 304 definiert ist, und zwischen einem freiliegenden Bereich der Oberfläche 302a der drei ersten Leiterbahnen 302 und einem freiliegenden Bereich der Oberfläche 304a der drei zweiten Leiterbahnen 304 angeordnete molekularelektronische Moleküle 305, deren Länge gleich dem Abstand zwischen den drei ersten Leiterbahnen 302 und den drei zweiten Leiterbahnen 304 ist. Ferner sind gemäß der Molekularelektronik-Anordnung 300 die drei ersten Leiterbahnen 302 und die drei zweiten Leiterbahnen 304 jeweils mit einem elektrisch leitfähigen Kopplungselement 306 gekoppelt, mittels derer die Leiterbahn 302, 304 an einen externen Schaltkreis 307 ankoppelbar sind. Die elektrisch leitfähigen Kopplungselemente 306, die mit den drei zweiten Leiterbahnen 304 gekoppelt sind, sind in **Fig. 3A, Fig. 3B** nicht gezeigt. Eines der drei Kopplungselemente 306, mittels derer die drei ersten Leiterbahnen 302 an einen externen Schaltkreis ankoppelbar sind, sind in **Fig. 3B** gezeigt und sind mit einem elektrisch leitfähigen Material gefüllte Kontaktlöcher 306a, welche Kontaktlöcher 306a in das Substrat 301 eingebracht sind. Ferner ist in **Fig. 3B** ein externer Schaltkreis 307 gezeigt, der mittels der elektrisch leitfähigen Kopplungselemente 306 mit den drei ersten Leiterbahnen 302 und den drei zweiten Leiterbahnen 304 gekoppelt ist.

Aus der vergrößerten Darstellung eines molekularelektronischen Moleküls 308, die in **Fig. 3B** eingezeichnet ist, ist ersichtlich, dass die molekularelektronischen Moleküle 305 eine Länge "l" aufweisen. Diese Länge "l" der molekularelektronischen Moleküle 305 ist im Wesentlichen gleich dem Abstand "d" zwischen den ersten Leiterbahnen 302 und den zweiten Leiterbahnen 304, wobei diese Dicke "d" durch die Dicke des Abstandshalters 303 vorgegeben ist.

Gemäß dem in **Fig. 3A, Fig. 3B** gezeigten Ausführungsbeispiel der erfindungsgemäßen Molekularelektronik-Anordnung 300, die als Molekularspeicher verwendbar ist, sind die molekularelektronischen Moleküle 305 Bis-Pyridinium-Moleküle.

Im Weiteren wird das Prinzip beschrieben, wie die Molekularelektronik-Anordnung 300 als Molekularspeicher verwendbar ist. Wie in **Fig. 3A** gezeigt, ist die Molekularelektronik-Anordnung 300 in der Draufsicht im Wesentlichen ein Gitter, das durch zwei übereinander gekreuzt angeordnete Leiterbahnen 302, 304 ausgebildet wird. In jedem Kreuzungsbereich einer der ersten mit einer der zweiten Leiterbahnen 302, 304 sind redoxaktive Bis-Pyridinium-Moleküle 305 eingebracht, mittels derer eine der ersten Leiterbahnen 302 mit einer der zweiten Leiterbahnen 304 gekoppelt ist, d.h. der Zwischenraum überbrückt ist. Die Bis-Pyridinium-Moleküle 305 haben wie oben beschrieben die Eigenschaft, dass sie in einem oxidierten Zustand und in einem reduzierten Zustand vorliegen können. In dem oxidierten Zustand weisen die Bis-Pyridinium-Moleküle 305 einen hohen elektrischen Widerstand auf, wohingegen im reduzierten Zustand die Bis-Pyridinium-Moleküle 305 einen geringen elektrischen Widerstand aufweisen. Durch Anlegen einer ausreichend großen Spannung zwischen die beiden Endabschnitte eines Bis-Pyridinium-Moleküls 305 kann das Bis-Pyridinium-Molekül 305 zwischen den beiden Redoxzuständen reversibel hin und her geschaltet werden. Wiederum bezugnehmend auf **Fig. 3B** kann beispielsweise eine durch den externen Schaltkreis 307 bereitgestellte Spannung zwischen eine der ersten Leiterbahnen 302 und eine der zweiten Leiterbahnen 304 angelegt werden, dann liegt auch eine Spannung zwischen den Thiol-Endgruppen des Bis-Pyridinium-Moleküls 305 an. Durch Anlegen einer solchen geeigneten Spannung kann daher in jedem Kreuzungsbereich einer der ersten Leiterbahnen 302 mit einer der zweiten Leiterbahn 304 ein in diesem Kreuzungsbereich angeordnetes Bis-Pyridinium-Molekül 305 zwischen seinen beiden Redoxzuständen hin und her geschaltet werden. Mit anderen Worten ist durch eine geeignet gewählte Spannung einstellbar, ob ein Bis-Pyridinium-Molekül 305 in einem oxidierten Zustand mit einem hohen elektrischen Widerstand oder in einem reduzierten Zustand mit einem geringen elektrischen Widerstand vorliegt. Auf diese Weise kann jeder Kreuzungsbereich einer der ersten Leiterbahn 302 mit einer der zweiten Leiterbahn 304 als Molekularspeicher mit einer Datenmenge von einem Bit angesehen werden, das durch Anlegen einer ausreichend hohen Spannung mit einem logischen Wert "1" (oxidiert, hoher elektrischer Widerstand) oder "0" (reduziert, geringer elektrischer Widerstand) belegt werden kann. Gemäß dem in **Fig. 3A** und **Fig. 3B** gezeigten Ausführungsbeispiel der Molekularelektronik-Anordnung 300 sind damit insgesamt neun Bit speicherbar. So kann beispielsweise in einem Kreuzungsbereich einer der ersten Leiterbahnen 302 mit einer der zweiten Leiterbahnen 304 ein dazwischen angeordnetes Bis-Pyridinium-Molekül 305 in den reduzierten Redoxzustand gebracht werden, sodass dieses Bis-Pyridinium-Molekül 305 einen geringen elektrischen Widerstand aufweist. Alternativ kann in einem Kreuzungsbereich einer der ersten Leiterbahnen 302 und einer der zweiten Leiterbahnen 304 ein Bis-Pyridinium-Molekül 305 in den oxidierten Redoxzustand gebracht werden, so dass das Bis-Pyridinium-Molekül 305 einen hohen elektrischen Widerstand aufweist. Ein Bis-Pyridinium-Molekül 305 in einem Zustand mit einem hohen elektrischen Widerstand kann dann beispielsweise als ein Bit mit einem logischen Wert "1" interpretiert werden, und ein Bis-Pyridinium-Molekül 305 in einem Zustand mit einem geringen elektrischen Widerstand kann beispielsweise als ein Bit mit einem logischen Wert "0" angesehen werden. Damit ist erfindungsgemäß realisiert, dass in jedem Kreuzungsbereich einer der ersten Leiterbahnen 302 mit einer der zweiten Leiterbahnen 304 eine Datenmenge von einem Bit einspeicherbar ist.

Im Weiteren wird beschrieben, wie die in jedem Kreuzungsbereich einer der ersten Leiterbahnen 302 mit einer der zweiten Leiterbahnen 304 gespeicherte Datenmenge von einem Bit auslesbar ist. Legt man zwischen eine der ersten Leiterbahnen 302 und eine der zweiten Leiterbahnen 304 mittels des externen Schaltkreises 307 eine elektrische Spannung an, so hängt der Stromfluss durch die Bis-Pyridinium-Moleküle 305, die zwischen den beiden Leiterbahnen 302, 304 eingebracht sind, davon ab, wie groß der elektrische Widerstand der Bis-Pyridinium-Moleküle 305 ist. Wurden zuvor die Bis-Pyridinium-Moleküle 305 in einen oxidierten Zustand mit einem hohen elektrischen Widerstand gebracht, so ist der Stromfluss gering. Wurden zuvor die Bis-Pyridinium-Moleküle 305 dagegen in einen reduzierten Zustand mit einem geringen elektrischen Widerstand versetzt, so ist gemäß dem ohmschen Gesetz der Stromfluss durch die Bis-Pyridinium-Moleküle 305 hoch. Ein hoher Stromfluss kann gemäß dem oben Gesagten als Bit mit einem logischen Wert "0", ein geringer Stromfluss kann gemäß dem oben Gesagten als ein Bit mit einem logischen Wert "1" interpretiert werden. Auf die beschriebene Weise ist die in jedem Kreuzungsbereich einer der ersten Leiterbahnen 302 und einer der zweiten Leiterbahnen 304 speicherbare Datenmenge von einem Bit auslesbar.

Die in den Kreuzungsbereichen der ersten Leiterbahnen 302 mit den zweiten Leiterbahnen 304 gespeicherte Datenmenge kann gelöscht werden, indem beispielsweise an alle Kreuzungsbereiche zwischen den entsprechenden ersten Leiterbahnen 302 und den entsprechenden zweiten Leiterbahnen 304 derartige elektrische Spannungen angelegt werden, dass alle Bis-Pyridinium-Moleküle 305 z.B. in den reduzierten Zustand mit einer hohen elektrischen Leitfähigkeit gebracht werden, was einem logischen Wert "0" entspricht. Dadurch sind alle Bits auf den logischen Wert "0" zurückgesetzt, d.h. die Information gelöscht.

Es ist zu betonen, dass in jedem Kreuzungsbereich einer der ersten Leiterbahnen 302 mit einer der zweiten Leiterbahn 304 eines oder eine Mehrzahl von Bis-Pyridinium-Molekülen 305 eingebracht sein kann/können, von denen jedes zwischen einem oxidierten, elektrisch schlecht leitfähigen und einem reduzierten, elektrisch gut leitfähigen Zustand reversibel hin und her geschaltet werden kann.

Ferner ist in der Molekularelektronik-Anordnung 300 der Erfindung keine Schutzschicht 213, wie sie beispielsweise in den Molekularelektronik-Anordnungen 210 bzw. 220 aus **Fig. 2B** bzw. **Fig. 2C** gezeigt sind, vorgesehen. Alternativ können auch bei der Molekularelektronik-Anordnung 300, die als Molekularspeicher ausgestaltet ist, Schutzschichten auf den ungenutzten freiliegenden Oberflächen der ersten Leiterbahnen 302 bzw. der zweiten Leiterbahnen 304 vorgesehen sein.

Im Folgenden werden Ausführungsbeispiele des erfindungsgemäßen Verfahrens zum Herstellen einer Molekularelektronik-Anordnung beschrieben.

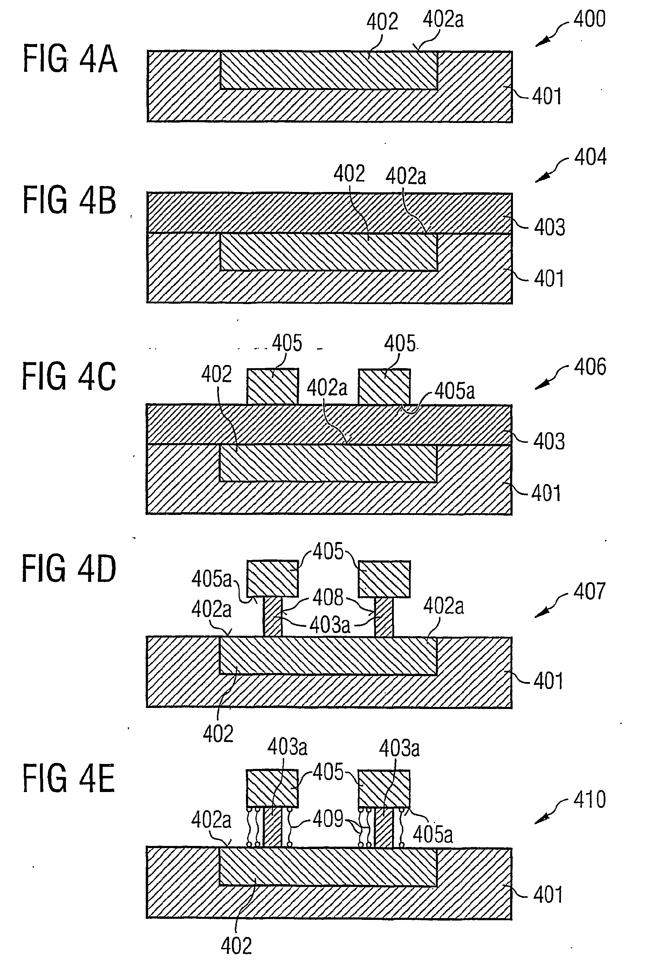

Bezugnehmend auf **Fig. 4A, Fig. 4B, Fig. 4C, Fig. 4D, Fig. 4E** wird im Weiteren ein erstes bevorzugtes Ausführungsbeispiel des erfindungsgemäßen Verfahrens zum Herstellen einer Molekularelektronik-Anordnung beschrieben.

Gemäß dem ersten bevorzugten Ausführungsbeispiel des Verfahrens zum Herstellen einer Molekularelektronik-Anordnung wird in einem ersten Schritt mindestens eine erste Leiterbahn 402, die eine Oberfläche 402a aufweist, in die Oberfläche eines Substrats 401 eingebracht.

Dadurch wird die Schichtanordnung 400 erhalten, die in **Fig. 4A** gezeigt ist. Gemäß dem beschriebenen Ausführungsbeispiel ist die mindestens eine Leiterbahn 402 aus Gold-Material hergestellt. Das Einbringen der mindestens einen Leiterbahn 402 in das Substrat 401 erfolgt in Damascene-Technik. Wie oben beschrieben, wird gemäß der Damascene-Technik in die Oberfläche eines Substrats 401 zunächst ein Graben geätzt. Anschließend wird auf die Oberfläche der erhaltenen Schichtstruktur eine Metallschicht abgesetzt. Mittels CMP ("Chemical Mechanical Polishing") wird die aufgebrachte Metallschicht von der Oberfläche so weit abpoliert, dass Metall-Material nur in dem Graben zurückbleibt und eine Schichtstruktur mit einer planaren Oberfläche 402a erhalten wird. Gemäß dem beschriebenen Ausführungsbeispiel wird als Substrat 401 ein vorprozessierter Silizium-Wafer verwendet.

In einem zweiten Verfahrensschritt des Ausführungsbeispiels des Verfahrens zum Herstellen einer Molekularelektronik-Anordnung wird auf die Oberfläche 402a der mindestens einen ersten Leiterbahn 402 eine Abstandshalter-Schicht 403 aufgebracht, welche die Oberfläche 402a der mindestens einen ersten Leiterbahn 402 mindestens teilweise bedeckt.

Gemäß dem beschriebenen Ausführungsbeispiel wird die Abstandshalter-Schicht 403 auf die Schichtstruktur 400 unter Verwendung des ALD-Verfahrens (Atomic Layer Deposition) aufgebracht, um die in **Fig. 4B** gezeigte Schichtanordnung 404 zu erhalten. Als Material für die Abstandshalter-Schicht 403 wird Siliziumdioxid verwendet. Wie oben beschrieben, ist das ALD-Verfahren ein modifiziertes CVD-Verfahren ("Chemical Vapour Deposition"), bei dem die Schichtdicke bis auf eine Genauigkeit einer Atomlage (d.h. bis in den Bereich weniger Angström) dadurch eingestellt werden kann, dass abwechselnd zwei Reaktionsgase in einen Verfahrensraum eingeleitet werden, wobei sich jeweils eine monoatomare Schicht auf der Oberfläche absetzt. Durch geeignete Wahl der Anzahl der Verfahrensschritte ist die Dicke der Abstandshalter-Schicht 403 daher als Folge des Verwendens des ALD-Verfahrens sehr genau einstellbar.

In einem nächsten Verfahrensschritt wird mindestens eine zweite Leiterbahn 405, die eine Oberfläche 405a aufweist, die der Oberfläche 402a der mindestens einen ersten Leiterbahn 402 flächig gegenüberliegt, auf die Abstandshalter-Schicht 403 aufgebracht, wobei mittels der Abstandshalter-Schicht 403 ein Abstand zwischen der mindestens einen ersten Leiterbahn 402 und der mindestens einen zweiten Leiterbahn 405 vorgegeben wird.

Dadurch wird die Schichtstruktur 406 erhalten, die in **Fig. 4C** gezeigt ist. Der beschriebene Verfahrensschritt weist mehrere Teilschritte auf. In einem ersten Teilschritt wird eine Goldschicht auf die Oberfläche der Schichtanordnung 404 aufgebracht. In einem zweiten Schritt wird unter Verwendung eines geeigneten Lithographie- und Ätzverfahrens die aufgebrachte Goldschicht derartig strukturiert, dass die mindestens eine zweite Leiterbahn 405 auf der Oberfläche der Schichtstruktur 406 zurückbleibt. Gemäß dem beschriebenen Ausführungsbeispiel werden verfahrensgemäß zwei zweite Leiterbahnen 405 hergestellt.

In einem nächsten Verfahrensschritt werden zwei Abstandshalter 403a ausgebildet, indem die Abstandshalter-Schicht 403 teilweise zurückgeätzt wird, derart, dass ein freiliegender Bereich der Oberfläche der mindestens einen ersten Leiterbahn 402 und ein freiliegender Bereich der Oberfläche der mindestens einen zweiten Leiterbahn 405 zurückbleibt.

Mit anderen Worten wird in diesem Verfahrensschritt die Abstandshalter-Schicht 403 derartig zurückgeätzt, dass Abstandshalter 403a zurückbleiben. Dies erfolgt gemäß dem beschriebenen Ausführungsbeispiel des Verfahrens zum Herstellen einer Molekularelektronik-Anordnung mittels nasschemischen Zurückätzens der aus Siliziumdioxid hergestellten Abstandshalter-Schicht 403. Die aus diesem Verfahrensschritt resultierende Schichtanordnung 407 ist in **Fig. 4D** gezeigt. Wie in **Fig. 4D** gezeigt, erfolgt eine Unterätzung der Abstandshalter 403a, so dass die zurückbleibenden Bereiche der Abstandshalter 403a in gemäß **Fig. 4D** horizontaler Richtung ausreichend schmal sind, dass in mindestens einem Kreuzungsbereich einer der ersten Leiterbahnen 402 mit einer der zweiten Leiterbahnen 405 freiliegende Oberflächen 402a, 405a der ersten bzw. zweiten Leiterbahnen 402, 405 zurückbleiben. Mit anderen Worten werden durch die beidseitig seitlich über die Abstandshalter 403a überstehenden ersten und zweiten Leiterbahnen 402, 405 Nuten 408 ausgebildet, in denen sich die beiden Leiterbahnebenen planparallel gegenüberstehen und in die molekularelektronische Moleküle einer geeigneten Dicke einbringbar sind.

In einem weiteren Verfahrensschritt werden zwischen dem freiliegenden Bereich der Oberfläche der mindestens einen ersten Leiterbahn 402 und dem freiliegenden Bereich der Oberfläche der mindestens einen zweiten Leiterbahn 405 molekularelektronische Moleküle 409 angeordnet, deren Länge gleich dem Abstand zwischen der mindestens einen ersten Leiterbahn 402 und der mindestens einen zweiten Leiterbahn 405 ist.

Dadurch wird die Schichtanordnung 410 erhalten, die in Fig. 4E gezeigt ist. Indem die Oberflächen 402a, 405a der ersten und zweiten Leiterbahnen 402, 405 teilweise freigelegt sind und in einem Abstand voneinander vorgesehen sind, die der Länge der einzubringenden molekularelektronischen Moleküle 409 entspricht, und indem als Material für die ersten und zweiten Leiterbahnen 402, 405 Gold-Material gewählt wird, an das molekularelektronische Moleküle 409 über Thiol-Gruppen gut anbinden können, sind Vorkehrungen getroffen, um das Anbinden molekularelektronischer Moleküle 409 an die Leiterbahnen 402, 405 zu realisieren. Gibt man nun die molekularelektronischen Moleküle 409 auf die Schichtanordnung 407, beispielsweise in gelöster Form, so erfolgt automatisch eine beidseitige Ankopplung der molekularelektronischen Moleküle 409 mit einer der ersten Leiterbahnen 402 und einer der zweiten Leiterbahnen 405. Da die Ankopplung ohne äußere Einwirkung von selbst vonstatten geht, spricht man auch von Self-Assembly-Technik.

Die in **Fig. 4E** gezeigte Schichtanordnung 410 entspricht weitgehend der in **Fig. 2A** gezeigten Molekularelektronik-Anordnung 200.

In einem weiteren Verfahrensschritt kann mindestens eine der ersten Leiterbahnen 402 und/oder mindestens eine der zweiten Leiterbahnen 405 mit mindestens einem elektrisch leitfähigen Kopplungselement gekoppelt werden, sodass die Leiterbahnen 402, 405 an einen externen Schaltkreis ankoppelbar sind. Darüber hinaus kann in einem weiteren Verfahrensschritt ein Teil der ersten und/oder der zweiten Leiterbahnen 402, 405 mittels der elektrisch leitfähigen Kopplungselemente mit einem externen Schaltkreis gekoppelt werden. Zum Ausbilden der elektrisch leitfähigen Kopplungselemente können in das Substrat 401 Kontaktlöcher eingebracht werden und die Kontaktlöcher mit einem elektrisch leitfähigen Material gefüllt werden.

Die Verfahrensschritte, durch welche die Kontaktlöcher in das Substrat 401 eingebracht werden bzw. durch welche die Kontaktlöcher mit einem elektrisch leitfähigen Material gefüllt werden, sind aus **Fig. 4A, Fig. 4B, Fig. 4C, Fig. 4D, Fig. 4E** nicht ersichtlich. Auch der externe Schaltkreis, der vorzugsweise in das Substrat 401 integriert ist, ist in **Fig. 4A, Fig. 4B, Fig. 4C, Fig. 4D, Fig. 4E** nicht gezeigt. Vorzugsweise werden die zugehörigen Verfahrensschritte durchgeführt, bevor die mindestens eine erste Leiterbahn 402, die eine Oberfläche 402a aufweist, in das Substrat 401 eingebracht wird. Mit anderen Worten wird das elektrisch leitfähige Kopplungselement und der externe Schaltkreis gemäß **Fig. 4A** von unten an die Schichtanordnung angeordnet.

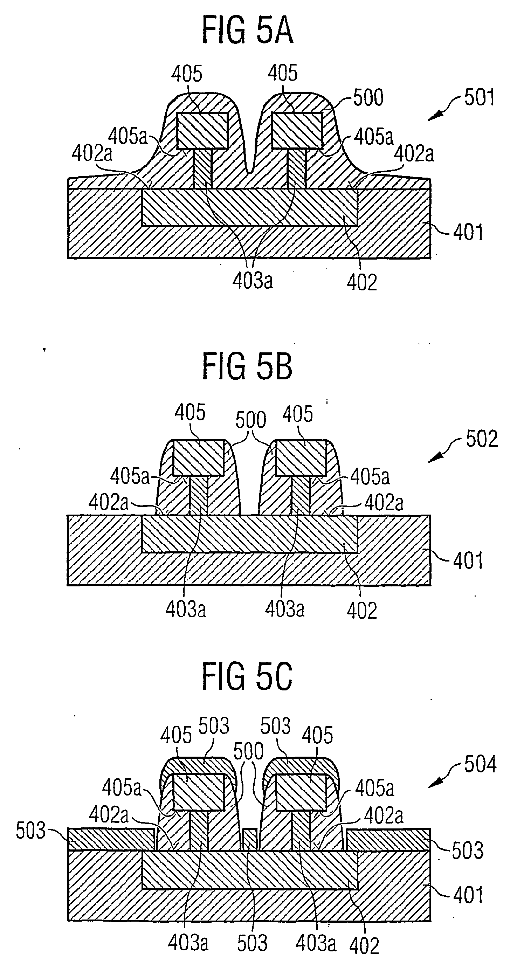

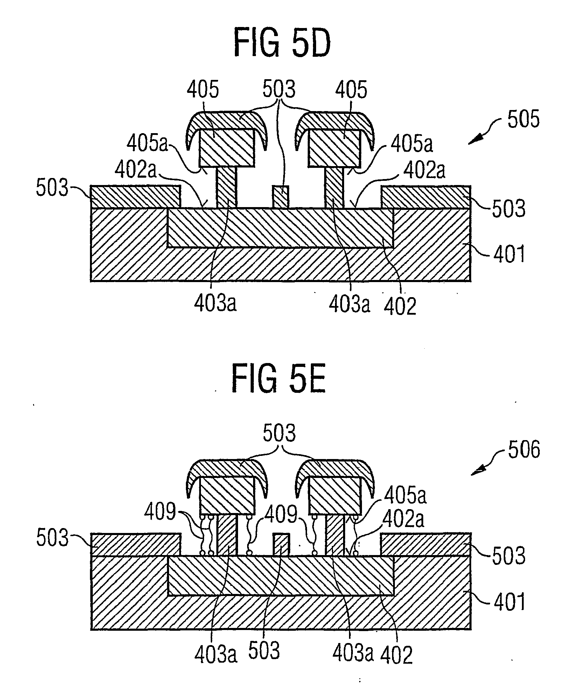

Im Weiteren wird bezugnehmend auf **Fig. 4A, Fig. 4B, Fig. 4C, Fig. 4D, Fig. 5A, Fig. 5B, Fig. 5C, Fig. 5D, Fig. 5E** ein zweites bevorzugtes Ausführungsbeispiel des erfindungsgemäßen Verfahrens zum Herstellen einer Molekularelektronik-Anordnung beschrieben.

Die ersten vier Verfahrensschritte gemäß dem zweiten -bevorzugten Ausführungsbeispiel des erfindungsgemäßen Verfahrens zum Herstellen einer Molekularelektronik-Anordnung sind identisch mit den ersten vier Verfahrensabschnitten, die oben bezugnehmend auf das erste bevorzugte Ausführungsbeispiel des erfindungsgemäßen Verfahrens zum Herstellen einer Molekularelektronik-Anordnung beschrieben sind. Nach Durchführung dieser Verfahrensschritte wird die in **Fig. 4D** gezeigte Schichtanordnung 407 erhalten. Diese wird als Ausgangspunkt für die Beschreibung des weiteren Verfahrensablaufs verwendet.

Abweichend von dem oben beschriebenen ersten bevorzugten Ausführungsbeispiel des Verfahrens zum Herstellen einer Molekularelektronik wird im Weiteren nicht der Verfahrensschritt durchgeführt, der von der in **Fig. 4D** gezeigten Schichtanordnung 407 auf die in **Fig. 4E** gezeigte Schichtanordnung 410 führt.

Stattdessen wird vor dem Einbringen der molekularelektronischen Moleküle in die Schichtanordnung 407 mindestens eine Schutzschicht 503 auf mindestens einen Teil der freiliegenden Bereiche der Oberflächen der ersten und/oder der zweiten Leiterbahnen 402, 405 aufgebracht.

Nach Durchführung dieses Verfahrensschrittes wird die in **Fig. 5D** gezeigte Schichtanordnung 505 erhalten, die mehrere Teilschritte aufweist. In einem ersten Teilschritt wird auf die Schichtanordnung 407 eine Hilfsschicht 500 aufgebracht, wodurch die in **Fig. 5A** gezeigte Schichtanordnung 501 erhalten wird. Gemäß dem beschriebenen Ausführungsbeispiel des Verfahrens zum Herstellen einer Molekularelektronik-Anordnung wird das Abscheiden der Hilfsschicht 500 durch eine CVD-Abscheidung einer Siliziumnitrid-Schicht realisiert.

In einem nachfolgenden Teilschritt wird die aufgebrachte Hilfsschicht 500 anisotrop zurückgeätzt. Dadurch wird die in **Fig. 5B** gezeigte Schichtanordnung 502 erhalten. Mit anisotropem Rückätzen ist gemeint, daß durch ein gerichtetes Ätzverfahren das Material der Hilfsschicht 500 in einer vorgebbaren Dicke von der Oberfläche der Schichtanordnung 501 abgetragen wird. Wie in **Fig. 5B** gezeigt, verbleibt das Material der Hilfsschicht 500 nach Durchführen des anisotropen Ätzens ausschließlich in Bereichen nahe der Seitenwände der Abstandshalter 403a und der zweiten Leiterbahnen 405. Dadurch werden Teilabschnitte der Oberfläche der Schichtstruktur 502 freigelegt. Insbesondere werden Teilbereiche der Oberfläche der ersten Leiterbahn 402 und Teilbereiche der zweiten Leiterbahn 405 freigelegt.

In einem nächsten Teilschritt wird eine Schutzschicht 503 auf die Oberfläche der Schichtanordnung 502 aufgebracht. Das Aufbringen der Schutzschidi 503, die gemäß dem zweiten bevorzugten Ausführungsbeispiels des erfindungsgemäßen Verfahrens zum Herstellen einer Molekularelektronik-Anordnung aus Siliziumdioxid-Material hergestellt wird, erfolgt "gerichtet". Das bedeutet, dass die Siliziumdioxid-Schicht auf die Schichtanordnung 502 aufgebracht wird, ohne dass eine Bedeckung der Seitenwände erfolgt. Dadurch wird die in **Fig. 5C** gezeigte Schichtanordnung 504 erhalten. Insbesondere bleiben, wie in **Fig. 5C** gezeigt, Oberflächenbereiche der Hilfsschicht 500 freiliegend.

In einem nächsten Teilschritt wird das Material der Hilfsschicht 500 durch nasschemisches Ätzen mit heißer Phosphorsäure (H₃PO₄) weggeätzt. Heiße Phosphorsäure hat die Eigenschaft, Siliziumnitrid-Material zu ätzen, wohingegen Siliziumdioxid-Material durch heiße Phosphorsäure nicht geätzt wird. Daher wird bei dem nasschemischen Ätzverfahren lediglich die Hilfsschicht 500 weggeätzt, wohingegen die Schutzschicht 503 nicht geätzt wird. Daraus resultiert die in **Fig. 5D** gezeigte Schichtanordnung 505.

Die in Fig. 5D gezeigte Schichtanordnung 505 entspricht im Wesentlichen dem bevorzugten Ausführungsbeispiel der Molekularelektronik-Anordnung 210, wie sie in **Fig. 2B** gezeigt ist. Insbesondere verbleiben an Teilen der freiliegenden Oberflächen der ersten Leiterbahn 402 und an Teilen der freiliegenden Oberflächen der zweiten Leiterbahn 405 Bereiche, die mit der Schutzschicht 503 aus Siliziumdioxid-Material bedeckt sind. Dadurch ist ein parasitäres Anbinden von molekularelektronischen Molekülen an solchen Oberflächenbereichen der ersten und zweiten Leiterbahnen 402, 405 vermieden, an denen aus geometrischen Gründen molekularelektronische Moleküle nicht simultan an eine der ersten Leiterbahnen 402 und an eine der zweiten Leiterbahnen 405 ankoppeln können.

In einem nachfolgenden Verfahrensschritt werden zwischen dem freiliegenden Bereich der Oberfläche der mindestens einen ersten Leiterbahn 402 und dem freiliegenden Bereich der Oberfläche der mindestens einen zweiten Leiterbahn 405 molekularelektronische Moleküle 409 angeordnet, deren Länge gleich dem Abstand zwischen der mindestens einen ersten Leiterbahn 402 und der mindestens einen zweiten Leiterbahn 405 ist. Die resultierende Schichtanordnung 506 mit den eingebrachten molekularelektronischen Molekülen 409 gemäß dem zweiten bevorzugten Ausführungsbeispiel des Verfahrens zum Herstellen einer Molekularelektronik-Anordnung ist in Fig. 5E gezeigt.

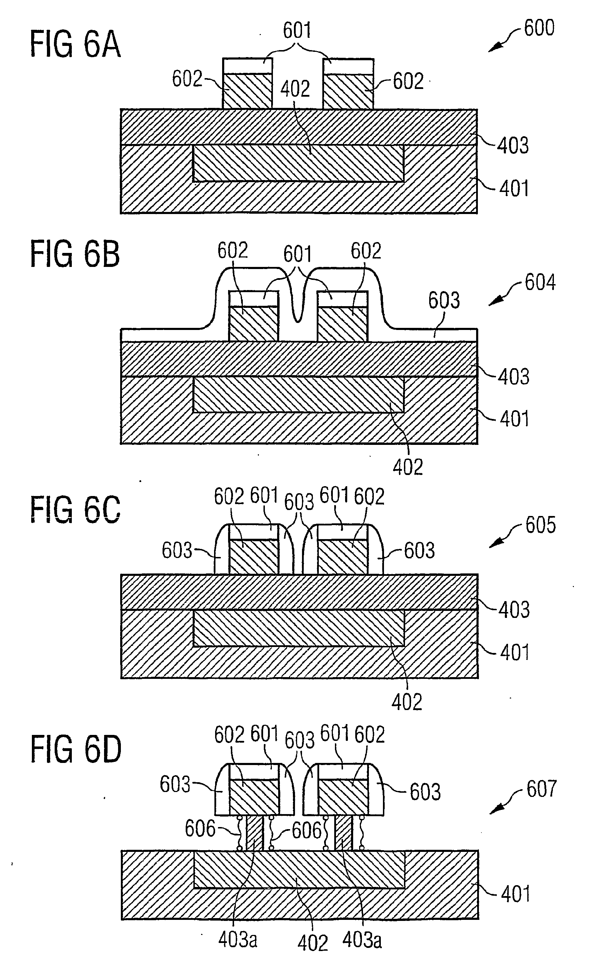

Im Weiteren wird bezugnehmend auf **Fig. 4A, Fig. 4B, Fig. 6A, Fig. 6B, Fig. 6C, Fig. 6D** ein drittes bevorzugtes Ausführungsbeispiel des erfindungsgemäßen Verfahrens zum Herstellen einer Molekularelektronik-Anordnung beschrieben.

Die ersten zwei Verfahrensschritte gemäß dem dritten bevorzugten Ausführungsbeispiel des erfindungsgemäßen Verfahrens zum Herstellen einer Molekularelektronik-Anordnung sind identisch mit den ersten zwei Verfahrensabschnitten, die oben bezugnehmend auf das erste bevorzugte Ausführungsbeispiel des erfindungsgemäßen Verfahrens zum Herstellen einer Molekularelektronik-Anordnung beschrieben sind. Nach Durchführung dieser Verfahrensschritte wird die in **Fig. 4B** gezeigte Schichtanordnung 404 erhalten. Diese wird als Ausgangspunkt für die Beschreibung des weiteren Verfahrensablaufs verwendet.

In einem nächsten Verfahrensschritt wird eine durchgehende Leiterschicht sowie eine weitere Schutzschicht 601 auf die Oberfläche der Schichtanordnung 404 aufgebracht.

Gemäß dem beschriebenen dritten bevorzugten Ausführungsbeispiel des erfindungsgemäßen Verfahrens zum Herstellen einer Molekularelektronik-Anordnung wird die Leiterschicht aus Goldmaterial auf der Oberfläche der Schichtanordnung 404 abgeschieden, und anschließend wird eine aus Siliziumnitrid-Material hergestellte weitere Schutzschicht 601 auf der Oberfläche der durchgehenden Leiterschicht abgeschieden.

Die durchgehende Leiterschicht und die weitere Schutzschicht 601 werden in einem nachfolgenden Verfahrensschritt derartig strukturiert, daß dadurch eine mindestens teilweise mit der weiteren Schutzschicht 601 bedeckte mindestens eine zweite Leiterbahn 602 ausgebildet wird.

Mit anderen Worten werden die aus Goldmaterial hergestellte Leiterschicht und die darüber angeordnete weitere Schutzschicht 601 gemeinsam strukturiert. Dies kann beispielsweise mittels eines geeigneten Photolithografie- und Ätzverfahrens erfolgen. Nach Durchführen dieses Verfahrensschrittes wird die in **Fig. 6A** gezeigte Schichtanordnung 600 erhalten.

In einem nachfolgenden Verfahrensschritt wird noch vor dem Einbringen von molekularelektronischen Molekülen in die Anordnung eine Schutzschicht 603 auf mindestens einen Teil der freiliegenden Bereiche der Oberflächen der ersten und/oder der zweiten Leiterbahnen 402, 602 aufgebracht. Der beschriebene Verfahrensschritt weist mehrere Teilschritte auf.

In einem ersten Teilschritt wird eine Schutzschicht 603 auf der gesamten Oberfläche der Schichtanordnung 600 aufgebracht. Dies ist erfindungsgemäß realisiert, indem unter Verwendung des CVD-Verfahrens eine Siliziumnitrid-Schicht auf der Oberfläche der Schichtanordnung 600 abgeschieden wird, wodurch die in **Fig. 6B** gezeigte Schichtanordnung 604 erhalten wird.

In einem weiteren Teilschritt wird die Schutzschicht 603 anisotrop zurückgeätzt, wodurch die in **Fig. 6C** gezeigte Schichtanordnung 605 erhalten wird. Mit anderen Worten wird von der gesamten Oberfläche der Schichtanordnung 604 Material der Schutzschicht 603 einer vorgebbaren Dicke weggeätzt, sodass, wie in **Fig. 6C** gezeigt, auf der Oberfläche der Schichtanordnung 605 Bereiche der Abstandshalter-Schicht 403 freigelegt werden.

In einem weiteren Verfahrensschritt werden Abstandshalter 403a mittels teilweisen Zurückätzens der Abstandshalter-Schicht 403 ausgebildet, derart, daß ein freiliegender Bereich der Oberfläche der mindestens einen ersten Leiterbahn 402 und ein freiliegender Bereich der Oberfläche der mindestens einem zweiten Leiterbahn 602 zurückbleibt.

Dieser Verfahrensschritt wird realisiert, indem die aus Siliziumdioxid-Material hergestellte Abstandshalter-Schicht 403 nasschemisch zurückgeätzt wird und unterätzt wird. Dadurch werden Abstandshalter 403a ausgebildet, sodass, wie in **Fig. 6D** gezeigt, die ersten Leiterbahnen 402 und die zweiten Leiterbahnen 602 seitlich beidseitig über die Abstandshalter 403a hinausstehen. Anschaulich sind gemäß dem dritten bevorzugten Ausführungsbeispiel des erfindungsgemäßen Verfahrens zum Herstellen einer Molekularelektronik-Anordnung, wie in **Fig. 6D** gezeigt, die zweiten Leiterbahnen 602 mit einer U-förmigen Schutzschicht teilweise bedeckt, welche Schutzschicht durch die Schutzschicht 603 und die weitere Schutzschicht 601 ausgebildet ist. Daher ist der mit der Schutzschicht 601, 603 bedeckte Oberflächenbereich der zweiten Leiterbahn 602 vor einem parasitären Anbinden molekularelektronischer Moleküle geschützt.

In einem nächsten Verfahrensschritt werden zwischen dem freiliegenden Bereich der Oberfläche der mindestens einen ersten Leiterbahn 402 und dem freiliegenden Bereich der Oberfläche der mindestens einen zweiten Leiterbahn 602 molekularelektronische Moleküle 606 angeordnet, deren Länge gleich dem Abstand zwischen der mindestens einen ersten Leiterbahn 402 und der mindestens einen zweiten Leiterbahn 602 ist.

Nach Einbringen der Moleküle, die gemäß dem beschriebenen Ausführungsbeispiel des erfindungsgemäßen Verfahrens zum Herstellen einer Molekularelektronik-Anordnung Bis-Pyridinium-Moleküle sind, wird die in **Fig. 6D** gezeigte Schichtanordnung 607 erhalten. Die in **Fig. 6D** gezeigte Schichtanordnung 607 entspricht im Wesentlichen der in **Fig. 2C** gezeigten Molekularelektronik-Anordnung 220.

In diesem Dokument sind folgende Veröffentlichungen zitiert:
[1] Ellenbogen, JC, Love, JC (1999) "Architectures for molecular electronic computers; 1. Logic structures and an adder buildt from molecular electronic diodes", MITRE Nanosystems Group, McLean, Virginia
[2] Gittins, DI, Bethell, D, Schiffrin, DJ, Nichols, RJ (2000) "A nanometer-scale electronic switch consisting of a metal-cluster and redox-addressable groups" Nature 408:67-69
[3] DE 100 13 013 A1
[4] WO 01/27972 A2
[5] US 6,128,214
[6] US 5,270,965
[7] E. Emberly et. al, Principles for the design and operation of a molecular wire transistor, Journal of Applied Physics, 88(2000)9, S. 5280 - 5282, 2000
[8] J. Chen et. al., Large On-Off Ratios and Negative Differential Resistance in a Molecular Electronic Device, Science, 286, S. 1550 - 1552, 1999
[9] C.P. Collier et. al., Electronically Configurable Molecular-Based Logic Gates, Science, 285, S. 391 - 394, 1999
[10] R.M. Metzger et. al., Unimolecular Electrical Rectification in Hexadecylquinolinium Tricyanoquinodimethanide, Journal Am. Chem. Soc., 119, S. 10455 - 10466, 1997

### Bezugszeichenliste

- 100: Bis-Pyridinium-Molekül
- 101: erster Substituent
- 102: erste Alkyl-Gruppe
- 103: zweiter Substituent
- 104: zweite Alkyl-Gruppe
- 105: erster Sechsring
- 106: erstes Stickstoff-Ion
- 107a: erster von dritten Substituenten
- 107b: zweiter von dritten Substituenten
- 107c: dritter von dritten Substituenten
- 107d: vierter von dritten Substituenten
- 108: erstes Kohlenstoff-Atom
- 109: zweiter Sechsring
- 110: zweites Kohlenstoff-Atom
- 111a: erster von vierten Substituenten
- 111b: zweiter von vierten Substituenten
- 111c: dritter von vierten Substituenten
- 111d: vierter von vierten Substituenten
- 112: zweites Stickstoff-Ion
- 113: dritte Alkyl-Gruppe
- 114: fünfter Substituent
- 115: vierte Alkyl-Gruppe
- 116: sechster Substituent
- 117: Alkyl-Trichlorsilan-Molekül
- 118: Alkyl-Gruppe
- 119: Trichlorsilan-Rest
- 200: Molekularelektronik-Anordnung
- 201: Substrat
- 202: erste Leiterbahn
- 202a: Oberfläche der ersten Leiterbahn
- 203: Abstandshalter
- 204: zweite Leiterbahn
- 204a: Oberfläche der zweiten Leiterbahn
- 205: molekularelektronisches Molekül
- 206: vergrößerte Darstellung eines molekularelektronischen Moleküls
- 210: Molekularelektronik-Anordnung
- 211: elektrisch leitfähiges Kopplungselement
- 211a: Kontaktloch
- 212: Schaltkreis
- 213: Schutzschicht
- 220: Molekularelektronik-Anordnung
- 300: Molekularelektronik-Anordnung
- 301: Substrat
- 302: erste Leiterbahn
- 302a: Oberfläche der ersten Leiterbahn
- 303: Abstandshalter
- 304: zweite Leiterbahn
- 304a: Oberfläche der zweiten Leiterbahn
- 305: molekularelektronisches Molekül
- 306: elektrisch leitfähiges Kopplungselement
- 306a: Kontaktloch
- 307: Schaltkreis
- 308: vergrößerte Darstellung eines molekularelektronischen Moleküls
- 400: Schichtanordnung
- 401: Substrat
- 402: erste Leiterbahn
- 402a: Oberfläche der ersten Leiterbahn
- 403: Abstandshalter-Schicht
- 403a: Abstandshalter
- 404: Schichtanordnung
- 405: zweite Leiterbahn
- 405a: Oberfläche der zweiten Leiterbahn
- 406: Schichtanordnung
- 407: Schichtanordnung
- 408: Nuten
- 409: molekularelektronisches Molekül
- 410: Schichtanordnung
- 500: Hilfsschicht
- 501: Schichtanordnung
- 502: Schichtanordnung
- 503: Schutzschicht
- 504: Schichtanordnung
- 505: Schichtanordnung
- 506: Schichtanordnung
- 600: Schichtanordnung
- 601: weitere Schutzschicht
- 602: zweite Leiterbahn
- 603: Schutzschicht
- 604: Schichtanordnung
- 605: Schichtanordnung
- 606: molekularelektronische Moleküle
- 607: Schichtanordnung

## Patentansprüche

1. Molekularelektronik-Anordnung mit
• einem Substrat;
• mindestens einer ersten Leiterbahn, die eine Oberfläche aufweist, und die in oder auf dem Substrat angeordnet ist;
• einem auf der Oberfläche der mindestens einen ersten Leiterbahn angeordneten Abstandshalter, der die Oberfläche der mindestens einen ersten Leiterbahn teilweise bedeckt;
• mindestens einer auf dem Abstandshalter angeordneten zweiten Leiterbahn, die eine Oberfläche aufweist, die der Oberfläche der mindestens einen ersten Leiterbahn flächig gegenüberliegt, wobei der Abstandshalter die Oberfläche der mindestens einen zweiten Leiterbahn teilweise bedeckt, und wobei mittels des Abstandshalters ein vorgegebener Abstand zwischen der mindestens einen ersten Leiterbahn und der mindestens einen zweiten Leiterbahn definiert ist;
• zwischen einem freiliegenden Bereich der Oberfläche der mindestens einen ersten Leiterbahn und einem freiliegenden Bereich der Oberfläche der mindestens einen zweiten Leiterbahn angeordneten molekularelektronischen Molekülen, deren Länge im wesentlichen gleich dem Abstand zwischen der mindestens einen ersten Leiterbahn und der mindestens einen zweiten Leiterbahn ist.

2. Molekularelektronik-Anordnung nach Anspruch 1, bei der mindestens eine der ersten Leiterbahnen und/oder mindestens eine der zweiten Leiterbahnen mit mindestens einem elektrisch leitfähigen Kopplungselement gekoppelt ist/sind, mittels derer die Leiterbahnen an einen externen Schaltkreis ankoppelbar sind.

3. Molekularelektronik-Anordnung nach Anspruch 2, bei der das mindestens eine elektrisch leitfähige Kopplungselement ein mit einem elektrisch leitfähigen Material gefülltes Kontaktloch ist, welches Kontaktloch in das Substrat eingebracht ist.

4. Molekularelektronik-Anordnung nach Anspruch 2 oder 3, die ferner einen externen Schaltkreis aufweist, der mittels der elektrisch leitfähigen Kopplungselemente mit mindestens einer der ersten Leiterbahnen und/oder der zweiten Leiterbahnen gekoppelt ist.

5. Molekularelektronik-Anordnung nach Anspruch 4, bei welcher der externe Schaltkreis ein integrierter Schaltkreis ist, der in das Substrat eingebracht ist.

6. Molekularelektronik-Anordnung nach Anspruch 4 oder 5, bei welcher der externe Schaltkreis in CMOS-Technologie hergestellt ist.

7. Molekularelektronik-Anordnung nach einem der Ansprüche 1 bis 6, die ferner mindestens eine Schutzschicht auf mindestens einem Teil der freiliegenden Oberflächen der ersten und/oder der zweiten Leiterbahnen aufweist.

8. Molekularelektronik-Anordnung nach einem der Ansprüche 1 bis 7, bei der
das Substrat ein Silizium-Wafer ist.

9. Molekularelektronik-Anordnung nach einem der Ansprüche 1 bis 8, bei der
die Leiterbahnen aus einem oder einer Kombination der Materialien Gold, Platin, Silber, Silizium, Aluminium und Titan hergestellt sind.

10. Molekularelektronik-Anordnung nach einem der Ansprüche 1 bis 9, bei welcher der Abstandshalter aus einem oder einer Kombination der Materialien Siliziumdioxid und Siliziumnitrid hergestellt ist.

11. Molekularelektronik-Anordnung nach einem der Ansprüche 1 bis 10, bei der
zumindest ein Teil der molekularelektronischen Moleküle redoxaktive Bis-Pyridinium-Moleküle und/oder Alkyl-Trichlorsilan-Moleküle sind.

12. Molekularelektronik-Anordnung nach einem der Ansprüche 2 bis 11, bei der
die elektrisch leitfähigen Kopplungselemente aus PolySilizium-Material, Aluminium-Material oder Wolfram-Material hergestellt sind.

13. Molekularelektronik-Anordnung nach einem der Ansprüche 7 bis 12, bei der
die mindestens eine Schutzschicht aus einem oder einer Kombination der Materialien Siliziumdioxid und Siliziumnitrid hergestellt ist.

14. Molekularelektronik-Anordnung nach einem der Ansprüche 1 bis 13, bei der
die beiderseitige Kopplung der molekularelektronischen Moleküle mit den Leiterbahnen eine Thiol-Gold-Kopplung und/oder eine Kopplung einer Trichlorsilan-Gruppe mit einem der Materialien Silizium, Aluminium und Titan ist.

15. Verfahren zum Herstellen einer Molekularelektronik-Anordnung, bei dem
• mindestens eine erste Leiterbahn, die eine Oberfläche aufweist, in bzw. auf die Oberfläche eines Substrats eingebracht bzw. aufgebracht wird;
• auf die Oberfläche der mindestens einen ersten Leiterbahn eine Abstandshalter-Schicht aufgebracht wird, welche die Oberfläche der mindestens einen ersten Leiterbahn mindestens teilweise bedeckt;
• mindestens eine zweite Leiterbahn, die eine Oberfläche aufweist, die der Oberfläche der mindestens einen ersten Leiterbahn flächig gegenüberliegt, auf die Abstandshalter-Schicht aufgebracht wird, wobei mittels der Abstandshalter-Schicht ein Abstand zwischen der mindestens einen ersten Leiterbahn und der mindestens einen zweiten Leiterbahn vorgegeben wird;
• mindestens ein Abstandshalter ausgebildet wird, indem die Abstandshalter-Schicht teilweise zurückgeätzt wird, derart, dass ein freiliegender Bereich der Oberfläche der mindestens einen ersten Leiterbahn und ein freiliegender Bereich der Oberfläche der mindestens einen zweiten Leiterbahn zurückbleibt;
• zwischen dem freiliegenden Bereich der Oberfläche der mindestens einen ersten Leiterbahn und dem freiliegenden Bereich der Oberfläche der mindestens einen zweiten Leiterbahn molekularelektronische Moleküle angeordnet werden, deren Länge gleich dem Abstand zwischen der mindestens einen ersten Leiterbahn und der mindestens einen zweiten Leiterbahn ist.

16. Verfahren nach Anspruch 15, bei dem
ferner mindestens eine der ersten Leiterbahnen und/oder mindestens eine der zweiten Leiterbahnen mit mindestens einem elektrisch leitfähigen Kopplungselement gekoppelt werden, so dass die Leiterbahnen an einen externen Schaltkreis ankoppelbar sind.

17. Verfahren nach Anspruch 16, bei dem
die elektrisch leitfähigen Kopplungselemente ausgebildet werden, indem in das Substrat Kontaktlöcher eingebracht werden und die Kontaktlöcher mit einem elektrisch leitfähigen Material gefüllt werden.

18. Verfahren nach Anspruch 16 oder 17, bei dem
mindestens ein Teil der ersten und/oder der zweiten Leiterbahnen mittels der elektrisch leitfähigen Kopplungselemente mit einem externen Schaltkreis gekoppelt werden.

19. Verfahren nach einem der Ansprüche 15 bis 18, bei dem vor dem Einbringen der molekularelektronischen Moleküle in die Anordnung mindestens eine Schutzschicht auf mindestens einen Teil der freiliegenden Bereiche der Oberflächen der ersten und/oder der zweiten Leiterbahnen aufgebracht wird.

20. Verfahren nach einem der Ansprüche 15 bis 19, bei dem statt dem Aufbringen der mindestens einen zweiten Leiterbahn auf die Abstandshalter-Schicht
• eine durchgehende Leiterschicht sowie eine weitere Schutzschicht auf die Oberfläche der Anordnung aufgebracht werden; und
• die durchgehende Leiterschicht und die weitere Schutzschicht derart strukturiert werden, dass **dadurch** mindestens eine mindestens teilweise mit der weiteren Schutzschicht bedeckte zweite Leiterbahn ausgebildet wird.

21. Verfahren nach einem der Ansprüche 15 bis 20, bei dem beim Einbringen der molekularelektronischen Moleküle in die Anordnung zumindest an einen Teil der Leiterbahnen elektrische Spannungen angelegt werden, derart, dass die molekularelektronischen Moleküle mit einer bevorzugten geometrischen Orientierung an eine der mindestens einen ersten Leiterbahnen und an eine der mindestens einen zweiten Leiterbahnen gekoppelt werden.

22. Verfahren nach einem der Ansprüche 15 bis 21, bei dem die mindestens eine erste Leiterbahn in die Oberfläche des Substrats in Damascene-Technik eingebracht wird.

23. Verfahren nach einem der Ansprüche 15 bis 22, bei dem die Abstandshalter-Schicht auf die Oberfläche der Schichtanordnung mittels Atomic Layer Deposition aufgebracht wird.

24. Verfahren nach Anspruch 18, bei dem
der externe Schaltkreis in das Substrat integriert wird.

25. Verfahren nach Anspruch 24, bei dem
der externe Schaltkreis in das Substrat mittels CMOS-Technologie integriert wird.

26. Verfahren nach einem der Ansprüche 15 bis 25, bei dem als Substrat ein Silizium-Wafer verwendet wird.

27. Verfahren nach einem der Ansprüche 15 bis 26, bei dem die Leiterbahnen aus einem oder einer Kombination der Materialien Gold, Platin, Silber, Silizium, Aluminium und Titan hergestellt werden.

28. Verfahren nach einem der Ansprüche 20 bis 27, bei dem unabhängig voneinander der Abstandshalter, die Schutzschicht und/oder die weitere Schutzschicht aus einem oder einer Kombination der Materialien Siliziumdioxid und Siliziumnitrid hergestellt werden.

29. Verfahren nach einem der Ansprüche 15 bis 28, bei dem als molekularelektronische Moleküle redoxaktive Bis-Pyridinium-Moleküle und/oder Alkyl-Trichlorsilan-Moleküle verwendet werden.

30. Verfahren nach einem der Ansprüche 16 bis 29, bei dem die elektrisch leitfähigen Kopplungselemente aus Poly-SiliziumMaterial, Aluminium-Material oder Wolfram-Material hergestellt werden.

## Claims

1. A molecular electronics arrangement having
• a substrate;
• at least one first interconnect, which has a surface and which is arranged in or on the substrate;
• a spacer arranged on the surface of the at least one first interconnect, which spacer partly covers the surface of the at least one first interconnect;
• at least one second interconnect arranged on the spacer, which second interconnect has a surface areally opposite the surface of the at least one first interconnect, the spacer partly covering the surface of the at least one second interconnect, and a predetermined distance between the at least one first interconnect and the at least one second interconnect being defined by means of the spacer;
• molecular electronic molecules arranged between an uncovered region of the surface of the at least one first interconnect and an uncovered region of the surface of the at least one second interconnect, the length of which molecules is essentially equal to the distance between the at least one first interconnect and the at least one second interconnect.

2. The molecular electronics arrangement as claimed in claim 1, in which at least one of the first interconnects and/or at least one of the second interconnects are/is coupled to at least one electrically conductive coupling element, by means of which the interconnects can be coupled to an external circuit.

3. The molecular electronics arrangement as claimed in claim 2, in which the at least one electrically conductive coupling element is a contact hole filled with an electrically conductive material, which contact hole is introduced into the substrate.

4. The molecular electronics arrangement as claimed in claim 2 or 3, which furthermore has an external circuit, which is coupled to at least one of the first interconnects and/or of the second interconnects by means of the electrically conductive coupling elements.

5. The molecular electronics arrangement as claimed in claim 4, in which the external circuit is an integrated circuit introduced into the substrate.

6. The molecular electronics arrangement as claimed in claim 4 or 5, in which the external circuit is fabricated using CMOS technology.

7. The molecular electronics arrangement as claimed in one of claims 1 to 6,
which furthermore has at least one protective layer on at least one portion of the uncovered surfaces of the first and/or of the second interconnects.

8. The molecular electronics arrangement as claimed in one of claims 1 to 7, in which
the substrate is a silicon wafer.

9. The molecular electronics arrangement as claimed in one of claims 1 to 8, in which
the interconnects are fabricated from one or a combination of the materials gold, platinum, silver, silicon, aluminum and titanium.

10. The molecular electronics arrangement as claimed in one of claims 1 to 9, in which
the spacer is fabricated from one or a combination of the materials silicon dioxide and silicon nitride.

11. The molecular electronics arrangement as claimed in one of claims 1 to 10, in which
at least a portion of the molecular electronic molecules are redox-active bispyridinium molecules and/or alkyltrichlorosilane molecules.

12. The molecular electronics arrangement as claimed in one of claims 2 to 11, in which
the electrically conductive coupling elements are fabricated from polysilicon material, aluminum material or tungsten material.

13. The molecular electronics arrangement as claimed in one of claims 7 to 12, in which
the at least one protective layer is fabricated from one or a combination of the materials silicon dioxide and silicon nitride.

14. The molecular electronics arrangement as claimed in one of claims 1 to 13, in which
the two-sided coupling of the molecular electronic molecules to the interconnects is a thiol-gold coupling and/or a coupling of a trichlorosilane group to one of the materials silicon, aluminum and titanium.

15. A method for fabricating a molecular electronics arrangement, in which
• at least one first interconnect, which has a surface, is introduced into or applied to the surface of a substrate;
• a spacer layer is applied to the surface of the at least one first interconnect, which spacer layer at least partly covers the surface of the at least one first interconnect;
• at least one second interconnect, which has a surface areally opposite the surface of the at least one first interconnect, is applied to the spacer layer, a distance between the at least one first interconnect and the at least one second interconnect being prescribed by means of the spacer layer;
• at least one spacer is formed by the spacer layer being partly etched back, in such a way that an uncovered region of the surface of the at least one first interconnect and an uncovered region of the surface of the at least one second interconnect remains;
• molecular electronic molecules are arranged between the uncovered region of the surface of the at least one first interconnect and the uncovered region of the surface of the at least one second interconnect, the length of which molecules is equal to the distance between the at least one first interconnect and the at least one second interconnect.

16. The method as claimed in claim 15, in which
furthermore at least one of the first interconnects and/or at least one of the second interconnects are coupled to at least one electrically conductive coupling element, so that the interconnects can be coupled to an external circuit.

17. The method as claimed in claim 16, in which
the electrically conductive coupling elements are formed by introducing contact holes into the substrate and filling the contact holes with an electrically conductive material.

18. The method as claimed in claim 16 or 17, in which
at least one portion of the first and/or of the second interconnects are coupled to an external circuit by means of the electrically conductive coupling elements.

19. The method as claimed in one of claims 15 to 18, in which
before the molecular electronic molecules are introduced into the arrangement, at least one protective layer is applied to at least one portion of the uncovered regions of the surfaces of the first and/or of the second interconnects.

20. The method as claimed in one of claims 15 to 19, in which
instead of the application of the at least one second interconnect to the spacer layer,
• a continuous conductor layer and also a further protective layer are applied to the surface of the arrangement; and
• the continuous conductor layer and the further protective layer are patterned in such a way that at least one second interconnect at least partly covered with the further protective layer is thereby formed.

21. The method as claimed in one of claims 15 to 20, in which
during the introduction of the molecular electronic molecules into the arrangement, electrical voltages are applied at least to a portion of the interconnects, in such a way that the molecular electronic molecules are coupled with a preferred geometrical orientation to one of the at least one first interconnects and to one of the at least one second interconnects.

22. The method as claimed in one of claims 15 to 21, in which
the at least one first interconnect is introduced into the surface of the substrate using damascene technology.

23. The method as claimed in one of claims 15 to 22, in which
the spacer layer is applied to the surface of the layer arrangement by means of atomic layer deposition.

24. The method as claimed in claim 18, in which
the external circuit is integrated into the substrate.

25. The method as claimed in claim 24, in which
the external circuit is integrated into the substrate by means of CMOS technology.

26. The method as claimed in one of claims 15 to 25, in which a silicon wafer is used as the substrate.

27. The method as claimed in one of claims 15 to 26, in which
the interconnects are fabricated from one or a combination of the materials gold, platinum, silver, silicon, aluminum and titanium.

28. The method as claimed in one of claims 20 to 27, in which
independently of one another, the spacer, the protective layer and/or the further protective layer are fabricated from one or a combination of the materials silicon dioxide and silicon nitride.

29. The method as claimed in one of claims 15 to 28, in which
redox-active bispyridinium molecules and/or alkyltrichlorosilane molecules are used as molecular electronic molecules.

30. The method as claimed in one of claims 16 to 29, in which the electrically conductive coupling elements are fabricated from polysilicon material, aluminum material or tungsten material.

## Revendications

1. Ensemble d'électronique moléculaire comprenant
• un substrat ;
• au moins une première piste conductrice qui a une surface et qui est disposée dans le substrat ou sur le substrat ;
• un intercalaire qui est disposé sur la surface de la au moins une première piste conductrice et qui recouvre en partie la surface de la au moins une première piste conductrice ;
• au moins une deuxième piste conductrice qui est disposée sur l'intercalaire et qui a une surface qui s'oppose en surface à la surface de la au moins une première piste conductrice, l'intercalaire recouvrant en partie la surface de la au moins une deuxième piste conductrice, et dans lequel il est défini au moyen de l'intercalaire une distance prescrite entre la au moins une première piste conductrice et la au moins une deuxième piste conductrice ;
• des molécules d'électronique moléculaire qui sont disposées entre une partie mise à nu de la surface de la au moins une première piste conductrice et une partie mise à nu de la surface de la au moins une deuxième piste conductrice, et dont la longueur est sensiblement égale à la distance entre la au moins une première piste conductrice et la au moins une deuxième piste conductrice.

2. Ensemble d'électronique moléculaire suivant la revendication 1, dans lequel au moins l'une des premières pistes conductrices et/ou au moins l'une des deuxièmes pistes conductrices est ou sont couplées à au moins un élément de couplage conducteur de l'électricité, au moyen duquel les pistes conductrices peuvent être couplées à un circuit extérieur.

3. Ensemble d'électronique moléculaire suivant la revendication 2, dans lequel le au moins un élément de couplage conducteur de l'électricité est un trou de contact qui est empli d'une matière conductrice de l'électricité et qui est ménagé dans le substrat.

4. Ensemble d'électronique moléculaire suivant la revendication 2 ou 3, qui a en outre un circuit extérieur qui est couplé, au moyen des éléments de couplage conducteurs de l'électricité, à au moins l'une des premières pistes conductrices et/ou des deuxièmes pistes conductrices.

5. Ensemble d'électronique moléculaire suivant la revendication 4, dans lequel le circuit extérieur est un circuit intégré qui est ménagé dans le substrat.

6. Ensemble d'électronique moléculaire suivant la revendication 4 ou 5, dans lequel le circuit extérieur est produit en technologie CMOS.

7. Ensemble d'électronique moléculaire suivant l'une des revendications 1 à 6,
qui a en outre au moins une couche de protection sur au moins une partie des surfaces mises à nu des premières et/ou des deuxièmes pistes conductrices.

8. Ensemble d'électronique moléculaire suivant l'une des revendications 1 à 7, dans lequel
le substrat est une tranche de silicium.

9. Ensemble d'électronique moléculaire suivant l'une des revendications 1 à 8, dans lequel
les pistes conductrices sont en un matériau ou en une combinaison des matériaux or, platine, argent, silicium, aluminium et titane.

10. Ensemble d'électronique moléculaire suivant l'une des revendications 1 à 9, dans lequel
l'intercalaire est en un matériau ou en une combinaison des matériaux dioxyde de silicium et nitrure de silicium.

11. Ensemble d'électronique moléculaire suivant l'une des revendications 1 à 10, dans lequel
au moins une partie des molécules d'électronique moléculaire sont des molécules de bis-pyridinium actives du point de vue redox et/ou des molécules d'alcoyl-trichlorosilane.

12. Ensemble d'électronique moléculaire suivant l'une des revendications 2 à 11, dans lequel
les éléments de couplage conducteurs de l'électricité sont en matériau de polysilicium, en matériau d'aluminium ou en matériau de tungstène.

13. Ensemble d'électronique moléculaire suivant l'une des revendications 7 à 12, dans lequel
la au moins une couche de protection est en un matériau ou en une combinaison des matériaux dioxyde de silicium et nitrure de silicium.

14. Ensemble d'électronique moléculaire suivant l'une des revendications 1 à 13, dans lequel
le couplage des deux côtés des molécules d'électronique moléculaire aux pistes conductrices est un couplage thiol-or et/ou un couplage d'un groupe trichlorosilane à l'un des matériaux silicium, aluminium et titane.

15. Procédé de production d'un ensemble d'électronique moléculaire, dans lequel
• on ménage ou on dépose au moins une première piste conductrice qui a une surface dans ou sur la surface d'un substrat ;
• on dépose sur la surface de la au moins une première piste conductrice une couche d'intercalaire qui recouvre au moins en partie la surface de la au moins une première piste conductrice ;
• on dépose sur la couche d'intercalaire au moins une deuxième piste conductrice qui a une surface qui s'oppose en surface à la surface de la au moins une première piste conductrice, une distance entre la au moins une première piste conductrice et la au moins une deuxième piste conductrice étant prescrite au moyen de la couche d'intercalaire ;
• on constitue au moins un intercalaire en attaquant latéralement en partie la couche d'entretoise, de façon à ce qu'il subsiste une partie mise à nu de la surface de la au moins une première piste conductrice et une partie mise à nu de la surface de la au moins une deuxième piste conductrice ;
• on dispose entre la partie mise à nu de la surface de la au moins une première piste conductrice et de la partie mise à nu de la surface de la au moins une deuxième piste conductrice des molécules d'électronique moléculaire dont la longueur est égale à la distance entre la au moins une première piste conductrice et la au moins une deuxième piste conductrice.

16. Procédé suivant la revendication 15, dans lequel on couple en outre au moins l'une des premières pistes conductrices et/ou au moins l'une des deuxièmes pistes conductrices à au moins un élément de couplage conducteur de l'électricité, de façon à ce que les pistes conductrices puissent être couplées à un circuit extérieur.

17. Procédé suivant la revendication 16, dans lequel
on constitue les éléments de couplage conducteurs de l'électricité en ménageant des trous de contact dans le substrat et en emplissant les trous de contact d'un matériau conducteur de l'électricité.

18. Procédé suivant la revendication 16 ou 17, dans lequel
on couple au moins une partie des premières et/ou des deuxièmes pistes conductrices à un circuit extérieur au moyen des éléments de couplage conducteurs de l'électricité.

19. Procédé suivant l'une des revendications 15 à 18, dans lequel
avant de mettre les molécules d'électronique moléculaire dans l'ensemble, on dépose au moins une couche de protection sur au moins une partie des parties mises à nu des surfaces des premières et/ou des deuxièmes pistes conductrices.

20. Procédé suivant l'une des revendications 15 à 19, dans lequel
au lieu du dépôt de la au moins une deuxième piste conductrice sur la couche intercalaire
• on dépose une couche conductrice continue ainsi qu'une autre couche de protection sur la surface de l'ensemble ; et
• on structure la couche conductrice continue et l'autre couche de protection, de façon à constituer ainsi au moins une deuxième piste conductrice recouverte au moins en partie de l'autre couche de protection.

21. Procédé suivant l'une des revendications 15 à 20, dans lequel
lors de la mise des molécules d'électronique moléculaire dans l'ensemble, on applique au moins à une partie des pistes conductrices des tensions électriques, de façon à ce que les molécules d'électronique moléculaire soient couplées en ayant une orientation géométrique préférée à l'une des au moins premières pistes conductrices et à l'une des au moins deuxièmes pistes conductrices.

22. Procédé suivant l'une des revendications 15 à 21, dans lequel
on ménage la au moins une première piste conductrice dans la surface du substrat suivant la technique damascène.

23. Procédé suivant l'une des revendications 15 à 22, dans lequel
on dépose la couche d'intercalaire sur la surface de l'ensemble stratifié au moyen d'une Atomic Layer Deposition.

24. Procédé suivant la revendication 18, dans lequel
on intègre la sûreté extérieure dans le substrat.

25. Procédé suivant la revendication 24, dans lequel
on intègre le circuit extérieur dans le substrat au moyen d'une technologie CMOS.

26. Procédé suivant l'une des revendications 15 à 25, dans lequel
on utilise comme substrat une tranche de silicium.

27. Procédé suivant l'une des revendications 15 à 26, dans lequel
les pistes conductrices sont en un matériau ou en une combinaison des matériaux or, platine, argent, silicium, aluminium et titane.

28. Procédé suivant l'une des revendications 20 à 27, dans lequel
indépendamment les uns des autres, l'intercalaire, la couche de protection et/ou l'autre couche de protection sont en un matériau ou en une combinaison des matériaux dioxyde de silicium et nitrure de silicium.

29. Procédé suivant l'une des revendications 15 à 28, dans lequel
on utilise comme molécule d'électronique moléculaire des molécules de bis-pyridinium actives du point de vue redox et/ou des molécules d'alcoyl-trichlorosilane.

30. Procédé suivant l'une des revendications 16 à 29, dans lequel
les éléments de couplage conducteurs de l'électricité sont en matériau de polysilicium, en matériau d'aluminium ou en matériau de tungstène.
